# FASCICULE DE BREVET EUROPEEN

(11) **EP 2 951 855 B1**
(45) Date de publication et mention de la délivrance du brevet: **24.10.2018**
(21) Numéro de dépôt: 13803174.5
(22) Date de dépôt: 26.11.2013
(51) Int. Cl.: H01L 21/02, H01L 31/0392, H01L 31/032

(54) **PROCÉDÉ DE PRÉPARATION DE COUCHE MINCE D'ABSORBEUR À BASE DE SULFURE(S) DE CUIVRE, ZINC ET ÉTAIN, COUCHE MINCE RECUITE ET DISPOSITIF PHOTOVOLTAÏQUE OBTENU**
VERFAHREN ZUR HERSTELLUNG EINER DÜNNEN SCHICHT EINES ABSORBERS AUS KUPFER, ZINK UND ZINNSULFID(EN), GETEMPERTE DÜNNSCHICHT UND SO HERGESTELLTES FOTOVOLTAIKMODUL
METHOD FOR PREPARING A THIN LAYER OF AN ABSORBER MADE OF COPPER, ZINC AND TIN SULFIDE(S), ANNEALED THIN LAYER AND PHOTOVOLTAIC DEVICE THUS OBTAINED

(30) Priorité: 29.01.2013 FR 1350741
(43) Date de publication de la demande: 09.12.2015
(73) Titulaire: IMRA EUROPE S.A., F-06560 Valbonne (FR)
(72) Inventeur: JACOB, Alain, F-06600 Antibes (FR); LARRAMONA, Gerardo, F-06560 Valbonne (FR); BOURDAIS, Stéphane, F-06600 Antibes (FR); CHONE, Christophe, F-06480 La Colle sur Loup (FR); CUCCARO, Yan, F-06600 Antibes (FR)
(74) Mandataire: Domange, Maxime
(86) Numéro de dépôt international: PCT/FR2013/052851
(87) Numéro de publication internationale: WO 2014/118444

(56) Documents cités:
- WO-A1-2012/071287
- WO-A1-2012/071288
- WO-A2-2012/071289
- KAZUYA MAEDA ET AL: "Influence of HS concentration on the properties of CuZnSnSthin films and solar cells prepared by sol gel sulfurization", SOLAR ENERGY MATERIALS AND SOLAR CELLS, ELSEVIER SCIENCE PUBLISHERS, AMSTERDAM, NL, vol. 95, no. 10, 31 mai 2011 (2011-05-31), pages 2855-2860, XP028241483, ISSN: 0927-0248, DOI: 10.1016/J.SOLMAT.2011.05.050 [extrait le 2011-06-18]
- Ankur Khare: "Synthesis And Characterization of Copper Zinc Tin Sulfide Nanoparticles And Thin Films", , 30 juin 2012 (2012-06-30), XP055080983, Extrait de l'Internet: URL:http://conservancy.umn.edu/bitstream/1 33748/1/Khare_umn_0130E_12926.pdf [extrait le 2013-09-25]
- TANAKA ET AL: "Preparation of Cu2ZnSnS4 thin films by sulfurizing sol-gel deposited precursors", SOLAR ENERGY MATERIALS AND SOLAR CELLS, ELSEVIER SCIENCE PUBLISHERS, AMSTERDAM, NL, vol. 91, no. 13, 5 juin 2007 (2007-06-05), pages 1199-1201, XP022104549, ISSN: 0927-0248

## Description

La présente invention concerne un procédé de fabrication de film ou couche mince de sulfure(s) métallique de cuivre, zinc et étain cristallisée à gros grains déposée sur un substrat. Plus particulièrement, la présente invention concerne un dispositif photovoltaïque solide comprenant une dite couche de sulfure(s) métallique à titre de couche d'absorption.

La présente invention concerne, plus particulièrement encore :
- un procédé de recuit de couche mince d'un matériau absorbeur à base de sulfure(s) de cuivre, zinc et étain, de préférence contenant majoritairement un composé quaternaire Cu-Zn-Sn-S (à savoir Cu₂ Zn Sn S₄ connue comme CZTS dénommée aussi kesterite), déposée sur un substrat recouvert de molybdène (ci-après désigné par « substrat Mo »),
- une couche mince CZTS sur substrat Mo recuite ainsi obtenue, et
- un dispositif photovoltaïque de type comprenant un dit substrat recouvert d'une dite couche mince d'absorption recuite.

Les dispositifs photovoltaïques du commerce sont du type silicium (Si), ou du type couche mince d'absorbeur à base de CdTe ou de CuGaₓIn_{y}Se₂ (dénommé CIGS). L'application principale de ces dispositifs photovoltaïques est comme générateur photovoltaïque domestique sur les toits des maisons. La puissance nominale typique de ces dispositifs est de l'ordre de 1-5 kilowatts (au point de puissance maximale), pour une surface de panneaux de l'ordre de 10 à 20 m² ce qui représente un rendement photovoltaïque nominale typique de l'ordre de 10-15%. Le problème principal des dispositifs du type Si est leur coût de fabrication et leur bilan énergétique. Le problème principal des dispositifs à base de CdTe et CIGS est celui d'utiliser certains composés à caractère toxique (tels que ceux faits à base de Cd, Se ou Te) ou d'utiliser certains éléments peu abondants (tel que l'indium, In).

Récemment, on a proposé un nouveau dispositif photovoltaïque de type couche mince, à base de sulfure de cuivre (Cu), zinc (Zn) et étain (Sn), Cu-Zn-Sn-S, communément dénommé CZTS, en remplacement du CIGS comme alternative utilisant des éléments très abondants. Le meilleur rendement photovoltaïque rapporté est de 8.4% (Shin et al. dans Prog. Photovolt. : Res. Appl., 21, 72, 2011). Une variante de ce dispositif comprend une couche mince d'absorbeur basée sur le sulfure-séléniure de cuivre, zinc et étain (nommé CZTSSe ou CZTSe), pour lequel le meilleur rendement rapporté est de 11.1% (Todorov et al. Adv. Energy Mat. 2012).

La structure la plus répandue de dispositif photovoltaïque basé sur le matériau absorbeur CZTS est celle du type dit substrat et comprend différentes couches plates empilées, typiquement, comprenant au moins :
- une couche conductrice optiquement transparente dite de contact avant, par exemple de type TCO (oxyde transparent conducteur), et
- une couche de composé isolant et transparent, par exemple une couche de ZnO ou ZnMgₓO₁₋ₓ, et
- une couche tampon de semi-conducteur de type n, par exemple de CdS ou In₂S₃ ou Zn(S,O,OH), et
- une couche dite couche d'absorption de type p, et
- une couche de matériau conducteur dite de contact arrière, par exemple une couche de métal molybdène (Mo), or (Au), graphite (C), Nickel (Ni) ou encore d'aluminium (Al), argent (Ag) ou indium (In).

Dans un dispositif photovoltaïque solide dit de type substrat, les couches ci-dessus sont complétées par :
- une grille métallique appliquée contre ladite couche de contact avant, constituant ainsi la face avant (côté soleil) du dispositif, et
- une couche de verre ou acier appliquée contre ladite couche de contact arrière.

Des dispositifs photovoltaïques solides à structure de type substrat sont bien connus de l'Homme de l'art. Ils sont par exemple décrits dans le livre « Thin film solar cells ; fabrication, characterization and applications, édité par Jef Poortmans et Vladimir Arkhipov, Wiley 2007.

La présente invention concerne une couche mince d'un matériau absorbeur à base de sulfure(s) de cuivre, zinc et étain, de préférence CZTS, notamment avec des pourcentages variables autour du composé stoechiométrique Cu₂ZnSnS₄, déposée sur un substrat recouvert de molybdène.

La différence majeure entre les différents dispositifs photovoltaïques comprenant une couche d'absorbeur CZTS réside dans le mode de fabrication de la couche de CZTS elle-même.

Des couches minces de CZTS ont été déposées par différents méthodes, utilisant des techniques de dépôt sous vide ou des techniques de dépôt à pression atmosphérique, notamment en utilisant des solutions ou suspensions dans des liquides. Dans la plupart des techniques, on dépose une ou plusieurs couches en utilisant des précurseurs comme des métaux (Cu, Sn, Zn ou des alliages), des mélanges de sulfures d'un seul métal (Cu₂S, CuS, ZnS, SnS, SnS₂), des sels des métaux dissoutes (avec ou sans précurseur de soufre), ou ses combinaisons. Dans d'autres techniques, on part du matériau CZTS déjà formé, comme des dispersions colloïdales, encres ou pâtes à base des particules (de taille micrométrique ou nanométrique) de CZTS (pour des dépôts liquides) ou de la poudre CZTS compactée en pastille frittée (pour des dépôts sous vide). Ces techniques permettent un meilleur contrôle de la stoechiométrie, lors de l'étape de fabrication des particules CZTS, avec un risque moindre de présence de phases secondaires, puisque le matériau de départ est le même que celui d'arrivée.

Les procédés de dépôt sous vide ont un coût de fabrication plus élevé. Parmi les procédés de dépôt avec des solutions liquides de précurseurs, celui utilisant le solvant hydrazine a permis d'atteindre un rendement photovoltaïque élevé, mais le solvant utilisé est très toxique. D'autres procédés mettant en oeuvre des solutions liquides de précurseurs utilisent d'autres solvants pas ou peu toxiques, et des techniques telles que la tournette (« spin coat », en anglais) ou l'électro-dépôt. Cependant, ils présentent des désavantages telles qu'un temps long de dépôt, l'impossibilité d'appliquer une méthode de dépôt industrielle en continu (« roll-to-roll » en anglais), ou la difficulté de contrôler la stoechiométrie du composé CZTS.

Les procédés de dépôt utilisant des dispersions colloïdales ou encres des particules du matériau CZTS, par des techniques telles que la pulvérisation (« spray » en anglais) ou le coulage en bande (« tape casting » en anglais), permettent un dépôt en continu, ce qui est préférable industriellement pour réduire le temps de fabrication et augmenter la reproductibilité.

La présente invention concerne le dépôt de la couche d'absorbeur par un procédé de dépôt à partir d'une dispersion colloïdale sous forme liquide déposée à pression atmosphérique, par exemple par pulvérisation ou par impression, ou d'une pâte déposée par exemple par coulage en bande, pour une fabrication de dispositifs photovoltaïques de type couche mince à base du matériau absorbeur CZTS, par dépôt rapide et à bas coût en utilisant des dispersions colloïdales ou des pâtes.

Différentes publications décrivent des couches CZTS réalisées avec des solutions colloïdales, des encres ou des pâtes à base de nanoparticules ou microparticules de CZTS. Dans certaines publications, la solution colloïdale ou encre est constituée d'un mélange de sulfures d'un ou deux métaux (comme Cu-S, Zn-S, Sn-S, Cu-Sn-S) (Akhavan et al., J. Solid State Chem. 189, 2, 2012, Todorov et al., Thin Solid Films 517, 2541, 2009), Wang et al., J. Alloys & Compounds 539, 237, 2012, et Zhou et al. Solar Energy Mat. & Solar Cells, 94, 2042, 2010). Ces articles rapportent une morphologie des couches à petits grains et/ou poreuse, ainsi qu'une faible performance photovoltaïque des dispositifs photovoltaïques fabriqués avec ces couches. Cette morphologie pourrait expliquer, au moins en partie, cette mauvaise performance.

Le dépôt de la couche CZTS est suivi, en général, d'un recuit à une température élevée, notamment aux alentours de 500°C. Un rôle possible du recuit est de permettre aux précurseurs présents dans la couche de réagir pour aboutir à la phase CZTS, dans les cas où celle-ci n'est pas encore formée à la fin du dépôt. Dans certains cas, le recuit est réalisé dans une atmosphère qui contient un précurseur de soufre (S), parce que la couche de précurseurs en est déficitaire ou parce que l'on observe une perte de soufre sous un recuit sans sa présence. Un autre rôle du recuit est d'augmenter la taille de grains et, éventuellement, densifier la couche, qui sont des propriétés requises pour une bonne performance photovoltaïque (en diminuant les recombinaisons possibles des porteurs de charge aux joints de grains, ou en évitant le court-circuit entre les parties du substrat Mo non-recouvertes (notamment des trous laissés dans la couche CZTS) et les couches au-dessus de la couche CZTS).

Différent types de recuits sont connus dans l'état de l'art. Ils se différentient principalement par le type d'atmosphère sous laquelle le recuit est réalisé. On connait notamment des recuits sous atmosphère neutre (azote ou argon notamment) à différentes pressions ou sous vide; ils sont appropriés pour les couches qui ont déjà un contenu suffisant en S. On connait aussi des recuits sous atmosphère contenant un précurseur de soufre, notamment du gaz H₂S (typiquement dilué dans l'argon ou l'azote) ou de la vapeur de S élémentaire (en chauffant de la poudre de S placée dans la même enceinte du recuit ou dans une enceinte annexe); ce type de recuit est notamment utilisé pour des couches des précurseurs CZTS qui ne contiennent pas ou sont déficitaires en S; des variantes de recuit sous Se élémentaire ou sous H₂Se sont connues pour échanger une partie du S par Se, pour ainsi arriver à une composition d'absorbeur du type CZTSSe.

Un exemple de recuit dans une atmosphère de H₂S est décrit dans l'article de Maeda et al. (Solar Energy Materials and Solar Cells, Elsevier Science Publishers, Amsterdam, Vol. 95 n° 10 pp 2855-2860 - 31 mai 2011), qui se rapporte à la préparation de couches minces de particules de CZTS par la méthode dite de « sol-gel » dans laquelle la couche est déposée sur un substrat en utilisant directement des précurseurs de sels de métaux sans utiliser de précurseurs chalcogénure notamment sans utiliser de précurseurs sulfure ou de soufre. Dans cet article, la couche déposée sur le substrat subit un unique recuit. Les couches de CSTZ obtenues dans cet article présentent une morphologie dans laquelle les gros grains de particules ne sont pas accolés en contact les uns contre les autres pour former une couche compacte mais présentent des trous nombreux et de grandes tailles. Les propriétés de la couche de CZTS obtenues (voir tableau 3 de cet article) fournissent un rendement photovoltaïque faible de pas plus de 2,23% et des valeurs d'intensité de courant à circuit ouvert « short circuit current » Jsc très faibles, à savoir inférieure ou égale à 10 mA/cm², ce qui représente des valeurs de moitié inférieure à ce qui est usuellement considéré comme nécessaire pour une couche d'absorption de CZTS approprié dans un dispositif photovoltaïque.

Enfin, on connait aussi des recuits sous atmosphère contenant de la vapeur de SnS, pouvant aussi contenir de la vapeur de S, (en chauffant des poudres de ces composés dans la même enceinte ou une enceinte annexe à celle du recuit); ce type de recuit est appliqué quand on suspecte la formation des phases secondaires comme le SnS ou la perte de Sn. Dans une variante, on utilise atmosphère contenant de la vapeur de SnSe dans le cas où on vise une composition CZTSSe.

Tous ces procédés de recuit sont faits dans une seule étape, dans une même atmosphère.

Le rôle du recuit est spécialement important pour des dépôts utilisant de dispersions colloïdales (ou encres ou pâtes) de particules, pour lesquelles il s'avère difficile de densifier la couche et d'augmenter suffisamment la taille des grains.

Un autre problème lors de la fabrication des couches CZTS est la présence de défauts dans les grains de CZTS eux-mêmes, qui peuvent favoriser la recombinaison de porteurs de charge, et donc diminuer la performance photovoltaïque. Dans l'état de l'art on ne sait pas bien contrôler la concentration pour diminuer ce type de défauts.

Un autre problème important lors de la fabrication des couches CZTS est celui de la présence indésirable des phases cristallines secondaires, en particulier des phases binaires et ternaires de sulfures d'un seul ou respectivement deux des métaux Cu, Zn et Sn, comme les composés Cu-S, Zn-S, Sn-S ou respectivement Cu-Sn-S. Dans les cas des dépôts à partir de dispersions colloïdales comprenant des particules de CZTS déjà formées, ces phases secondaires peuvent apparaître à cause de réactions de décomposition du matériau lui-même ou par interaction avec le substrat lors de l'étape de recuit à haute température. Certaines de ces phases secondaires sont suspectées de dégrader la performance photovoltaïque du fait qu'elles favoriseraient la recombinaison de porteurs de charge. Une de ces phases secondaires est le SnS, qui pourrait être formé lors d'une décomposition du CZTS en sulfures d'un seul métal (Cu₂S plus ZnS plus SnS₂), suivie d'une décomposition de SnS₂ en SnS.

Enfin, d'autres auteurs proposent des structures de couche CZTS totalement différentes, comme dans WO 2012/071288 et WO 2012/071289, où on décrit des couches de CZTS dites « MGL » constituées de particules de CZTS de tailles micrométriques, définies en page 9 ligne 25 à 29, qui sont liées (« embeded ») par une matrice inorganique. Dans les couches obtenues, les gros grains de particules de CZTS ne sont pas directement en contact les uns contre les autres, mais ils sont entourés d'une dite matrice plus ou moins amorphe et dont les gros grains sont séparés les uns des autres. Le rôle de la matrice inorganique est d'assurer l'adhérence des gros grains entre eux et sur le substrat. La couche d'absorbeur obtenue n'est donc pas homogène en cristallinité ni en composition. Les dispositifs photovoltaïques réalisés avec cette couche présentent des rendements photovoltaïques inférieurs à 0,1%.

Un but de la présente invention est de fournir un procédé de préparation de couche mince de matériau absorbeur constitué essentiellement de sulfure(s) de Cu, Zn et Sn avec des pourcentages atomiques des trois métaux Cu, Zn et Sn pouvant varier dans l'intervalle de x=40 à 60% pour le Cu et y= 15 à 35% pour le Zn et z= 15 à 35% Sn, avec x+y+z=100%, de préférence un composé CZTS, à partir de dispersions de particules de sulfure(s) de Cu, Zn et Sn, de préférence de dispersion de particules de CZTS, sous forme liquide, telle qu'une encre, ou sous forme de pâte, pour obtenir une couche cristallisée compacte, à gros grains, accolés en contact direct entre eux, avec moins de défauts et de préférence une homogénéité de la composition améliorée et/ou ne contenant pas ou peu de phases secondaires cristallines, notamment pas ou peu de phases binaires ou ternaires cristallines de sulfures d'un ou respectivement deux métaux choisis entre le Cu, Zn et Sn.

Un autre but de la présente invention est de fournir des dispositifs photovoltaïques de type comprenant une couche mince à base du matériau absorbeur CZTS, présentant une performance photovoltaïque améliorée, notamment des tensions à circuit ouvert supérieures à 0,45V et des courants à court-circuit supérieurs à 10mA/cm² et un rendement supérieur à 3%.

On entend ici par :
- «CZTS», le composé constitué au moins majoritairement, de préférence essentiellement, de sulfure(s) de Cu, Zn et Sn sous forme de composé quaternaire Cu-Zn-Sn-S, avec des pourcentages atomiques (c'est-à-dire le pourcentage de nombre d'atomes) des trois métaux Cu, Zn et Sn pouvant varier dans l'intervalle de x=40 à 60% pour le Cu et y= 15 à 35% pour le Zn et z= 15 à 35% Sn, avec x+y+z=100%, le composé stoechiométrique dont les pourcentages atomiques Cu :Zn :Sn sont de 50:25:25 correspondant au composé Cu₂ZnSnS₄, n'étant pas nécessairement la meilleure composition du point de vue qualité photovoltaïque.
- «matériau absorbeur constitué essentiellement de sulfure(s) de Cu, Zn et Sn », ledit matériau est constitué essentiellement de Cu, Zn et Sn et S , le composé pouvant contenir un petit pourcentage de pas plus de 4% (pourcentages atomiques) d'impuretés provenant d'autres éléments tels que Na et Cl ou autres provenant de l'utilisation de précurseurs de dites particules de sulfures métalliques telles que particules de CZTS, dans le procédé de préparation et/ou provenant du substrat et/ou l'enceinte du dépôt ou du recuit dans laquelle la fabrication a été réalisée ;
- «dispersion de particules sous forme liquide», un colloïde contenant une dispersion homogène de nanoparticules dont les dimensions vont de 2 à 500 nm et pouvant contenir des additifs pour assurer la dispersion et faciliter le dépôt sous forme d'encre, tels que des surfactants, des agents liants, des agents de blocage de surface («capping agents» en anglais), etc. ; la stabilité d'une telle dispersion homogène est due à la lenteur de la séparation des 2 phases solide et respectivement liquide.
- «dispersion de particules sous forme de pâte à base de particules», une dispersion similaire à un dit liquide, mais trop visqueuse pour couler et pouvant contenir des nanoparticules ou des microparticules de plus grandes tailles, notamment jusqu'à 5 µm, de préférence de pas plus de 2 µm ;
- «particules amorphes », des particules pas ou peu cristallisées, c'est-à-dire se caractérisant par l'absence de pic de diffraction bien défini mesuré par la technique diffraction de rayons X (dénommée DRX) ;
- «couche mince », une couche d'épaisseur de 0,5 à 5 µm, de préférence de 0,5 à 3 µm ;
- «couche dense» ou «couche compacte», une couche constituée de gros grains accolés en contact direct entre eux, au moins sur une partie de leur surface externe, et le taux de recouvrement de la surface du substrat par le dépôt de CZTS est de plus de 95%, plus particulièrement plus de 98%, et dont la couche présente une porosité inférieure à 10%, idéalement ne présentant pas de porosité apparente ;
- «gros grains», des particules de taille moyenne supérieure ou égale à 500 nm, plus particulièrement, une taille moyenne de l'ordre de 1 µm ou supérieur, résultant de la croissance desdites nanoparticules lors de l'étape de traitement thermique;
- «une couche avec peu ou pas de phases secondaires cristallines», une couche dont l'aire des pics principaux du DRX correspondant aux dites phases secondaires cristallines est inférieure à 1/50 à l'aire du pic principal de la phase cristalline quaternaire CZTS par mesure quantitative par DRX (Diffraction par Rayon X); et
- « composition homogène », une couche ne comportant pas de zone dont la composition en composition atomique élémentaire tel que constatée par cartographie EDX soit nettement différenciée par rapport à la composition moyenne de la couche.

Selon la présente invention, on a découvert que l'on pouvait obtenir une couche cristallisée compacte constituée essentiellement de gros grains cristallins, accolés en contact direct entre eux, de dit matériau absorbeur constitué essentiellement de sulfure(s) de Cu, Zn et Sn, de préférence de CZTS, avec moins de défauts voire une homogénéité de composition améliorée et/ou un contenu réduit de phases secondaires, avec notamment pas ou peu de phases binaires ou ternaires cristallines de sulfures d'un ou respectivement deux métaux choisis entre le Cu, Zn et Sn, en réalisant un procédé de double recuit dans des atmosphères déterminées des couches minces de particules d'un dit matériau absorbeur à base de sulfure de cuivre, zinc et étain, déposées sur un substrat recouvert de molybdène (Mo), ladite couche mince d'absorbeur recuite déposée sur ledit substrat Mo conférant des performances photovoltaïques améliorées à un dispositif photovoltaïque en comprenant conformément au but de la présente invention, notamment des tensions à circuit ouvert supérieures à 0,45V et des courants à court-circuit supérieurs à 10 mA/cm² et un rendement supérieur à 3%.

En particulier, les couches d'absorbeur ainsi obtenues confèrent des performances photovoltaïques améliorées au matériau absorbeur déposé sur un substrat.

Plus précisément, la présente invention fournit un procédé de fabrication d'une couche mince de matériau absorbeur composé essentiellement de sulfure(s) de Cu, Zn et Sn avec des pourcentages atomiques des trois métaux Cu, Zn et Sn pouvant varier dans l'intervalle de x=40 à 60% pour le Cu et y= 15 à 35% pour le Zn et z= 15 à 35% Sn, avec x+y+z=100%, de préférence sous forme de composé quaternaire Cu-Zn-Zn-S ci-après désigné par un composé CZTS, à gros grains cristallins de tailles moyennes au moins de 500 nm, ladite couche mince d'absorbeur étant déposée sur un (ou des) matériau(x) en couche(s) formant un substrat, dans lequel on réalise les étapes successives suivantes :
1) on dépose une couche à l'aide d'une de dispersion de particules, sous forme de liquide ou de pâte, lesdites particules étant des nanoparticules de sulfure(s) de Cu, Zn et Sn de tailles inférieures à 500 nm, de préférence de particules de CZTS, sur une couche de molybdène (Mo) d'un dit substrat recouvert d'une couche de molybdène (Mo), et
2) on réalise un traitement thermique de recuit de ladite couche déposée sur ledit substrat, à une température maximale d'au moins 300°C, de préférence au moins 450°C, pour obtenir une cristallisation et une croissance des particules pour obtenir des gros grains cristallins de tailles moyennes d'au moins 500 nm, sur une épaisseur de 0,5 à 5 µm, de préférence de 0,5 à 3 µm,
   caractérisé en ce que ledit traitement thermique comprend deux étapes de recuit dans des atmosphères différentes suivantes successives, à savoir:
   - une première étape de recuit dans une atmosphère de gaz neutre tel que l'azote (N₂) ou l'argon (Ar), et
   - une deuxième étape de recuit dans une atmosphère de gaz neutre tel que l'azote (N₂) ou l'argon (Ar) contentant du H₂S, de préférence contenant plus de 0,1%, de préférence encore plus de 1% en proportion molaire de H₂S notamment de 3 à 5%.

Le procédé de recuit des couches minces selon l'invention est avantageux en ce que :
- La première étape de recuit permet d'obtenir une densification et une croissance de taille des grains de la couche de particules ; et
- La deuxième étape de recuit permet d'améliorer l'homogénéité, notamment réduire le nombre de défauts et/ou réduire le contenu de phases secondaires qui ont pu apparaître lors de la première étape de recuit, et de recombiner les phases binaires ou ternaires en une phase quaternaire CZTS, et/ou la passivation de la surface du Mo accessible à cause de trous présents dans la couche.

Plus particulièrement, on densifie la couche et on fait croître les grains avant recuit grâce à un premier recuit en atmosphère neutre en présence du substrat Mo, qui pourrait produire une certaine ségrégation de phases (tel que le SnS) et/ou une augmentation des défauts. Le deuxième recuit en H₂S semble permettre de réduire les défauts et/ou de régénérer le CZTS, sans dégrader la taille des grains obtenu lors du premier recuit, grâce peut-être à l'oxydation du Sn(II) vers Sn(IV), qui est son degré d'oxydation dans le CZTS.

Ce procédé de recuit peut être réalisé avec les deux étapes de recuit bien différenciées, avec un cycle de refroidissement entre les deux étapes de recuit et éventuellement un changement d'appareil de recuit, ou bien, dans un seul appareil de recuit, avec changement d'atmosphère pendant que la couche est encore dans l'intervalle de température élevée.

Dans une variante de réalisation, dans la première étape, lesdites particules de ladite dispersion de particules peuvent être un mélange de particules de plusieurs sulfures d'un ou deux métaux choisis parmi Cu, Zn et Sn, de préférence des particules d'un seul métal comme Cu₂S, CuS, ZnS, SnS, SnS₂ ou des particules deux métaux comme Cu-Sn-S.

Plus particulièrement, la température maximale pour les deux première et deuxième étapes de recuit est de 450 à 600°C, de préférence de 500 à 590°C, et la durée du traitement à ladite température maximale est de 10 à 120 minutes, et la durée de la montée en température jusqu'à la température maximale est de préférence de 15 à 60 minutes.

Plus particulièrement encore, on réalise une étape intercalaire de refroidissement, de préférence jusqu'à température ambiante, entre les première et deuxième étapes de recuit, et de préférence la durée de la montée en température jusqu'à la température maximale lors desdites première et deuxième étapes de recuit étant de 30 à 60 minutes.

De préférence, ladite dispersion de particules est une dispersion colloïdale aqueuse, alcoolique ou hydro-alcoolique, de préférence une dispersion colloïdale hydro-alcoolique liquide de nanoparticules amorphes primaires de tailles de 2 à 100 nm de préférence inférieures à 30 nm, notamment de 3 à 20 nm.

Plus particulièrement, ladite dispersion colloïdale consiste en desdites nanoparticules en dispersion dans un solvant de dispersion consistant dans une dispersion aqueuse, alcoolique ou hydro alcoolique de nanoparticules amorphes, ledit alcool de ladite solution présentant une température d'ébullition inférieure à celle de l'eau, de préférence ledit solvant de dispersion consistant de préférence en un mélange eau/éthanol.

Plus particulièrement encore, ladite dispersion colloïdale ne contient pas de ligands organiques tels que définis ci-dessus. On entend ici par « nanoparticules primaires », des nanoparticules telles qu'obtenues avant leur agrégation ultérieure éventuelle sous forme d'agrégat de plus grande taille de plusieurs nanoparticules primaires entre elles.

L'obtention de nanoparticules primaires de plus petites tailles dispersées dans les solvants aqueux et/ou alcooliques de la présente invention est avantageux pour obtenir non seulement, dans un premier temps un colloïde stable sans ajout de ligand mais aussi dans un second temps un film homogène à gros grains cristallisés sans impuretés résiduelles de ligands organiques dans le procédé de fabrication décrit ci-après.

De préférence encore, ladite dispersion colloïdale est préparée en réalisant les étapes successives suivantes dans lesquelles :
a) on réalise une première solution aqueuse, alcoolique ou hydro-alcoolique de précurseurs de sulfures consistant dans un (ou des) sel(s) métallique(s) de sulfure(s), autres que des sels de cuivre, zinc et étain, de préférence dans de l'eau, ledit sel métallique de sulfure(s) étant de préférence un sel alcalin ou alcalino-terreux, de préférence encore un sel de sodium ou potassium, et
b) on réalise une deuxième solution de précurseurs de cuivre, zinc et étain, autres que des sulfures de cuivre, zinc et étain, en solution dans un solvant comprenant de l'acétonitrile pur ou en mélange avec de l'eau et/ou un alcool, de préférence autre que le méthanol, ledit sel de cuivre, zinc et étain étant de préférence un halogénure, de préférence encore un chlorure, et
c) on mélange à pression atmosphérique et température ambiante les 2 dites première et deuxième solutions de précurseurs jusqu'à obtenir une dispersion colloïdale brute, et
d) on sépare la partie solide de ladite dispersion colloïdale de l'étape c), de préférence par centrifugation pour obtenir un précipité du solide après retrait du surnageant liquide, et
e) on rince le précipité solide obtenu à l'étape d) en y versant un solvant aqueux, d'acétonitrile, alcoolique ou hydro-alcoolique pour réformer une dispersion colloïdale, l'alcool de ladite dispersion colloïdale alcoolique ou hydro-alcoolique étant de préférence de l'éthanol, et
f) on sépare à nouveau le précipité solide de ladite dispersion colloïdale de l'étape e), de préférence par centrifugation pour obtenir après retrait du surnageant liquide, un précipité rincé sous forme de pâte humide, et
g) de préférence, on réitère une ou plusieurs fois, les étapes e) et f) de rinçage du colloïde, par centrifugation puis une ré-dispersion dans un solvant aqueux, alcoolique ou hydro-alcoolique.

Plus particulièrement, à l'étape g), on ré-disperse ladite pâte humide de l'étape f) dans un solvant de dispersion comprenant, de préférence consistant dans une dispersion aqueuse, alcoolique ou hydro alcoolique, l'alcool de ladite solution alcoolique ou hydro alcoolique étant, le cas échéant, un alcool non toxique, notamment un alcool autre que le méthanol.

Selon la présente invention, dans le procédé de préparation de la dispersion colloïdale, on réalise donc la préparation préalable à température ambiante ou nécessitant un chauffage réduit de deux solutions séparées de précurseurs à base de sels de Cu, Zn et Sn et respectivement de sulfure avec des solvants différents, sans ajout de ligand, notamment aux étapes a) et b), et leur mélange à température réduite notamment à température ambiante et pression atmosphérique tel que défini aux étapes a) à c).

On entend ici par « ligand », une molécule organique apte à se lier et/ou à complexer un ou plusieurs des métaux Cu, Zn ou Sn, notamment une molécule organique substituée par au moins un groupe choisi parmi les groupes amine (-NH₂), thiol (-SH), amide ou thioamide, notamment -CONH₂ ou -CSNH₂, et/ou des groupes d'acide organique (tels que le groupe acide carboxylique -COOH ou un groupe acide phosphorique, notamment -PO₃H₂.

Une dispersion colloïdale stable à température ambiante obtenue sans ajout de ligand comprend moins d'impuretés résiduelles, ce qui contribue à améliorer la qualité d'un film obtenu après dépôt de la dispersion colloïdale et recuit de la couche résultante comme décrit ci-après. En particulier, ceci contribue à obtenir un film continu cristallisé à gros grains et plus homogène avec de meilleures performances photovoltaïques.

De préférence, à l'étape g) on met en oeuvre un solvant de dispersion consistant dans une dispersion aqueuse, alcoolique ou hydro alcoolique, l'alcool de ladite solution alcoolique ou hydro alcoolique étant un alcool non toxique présentant une température d'ébullition inférieure à la température d'ébullition de l'eau, de préférence de l'éthanol ou propanol, de préférence encore consistant en un mélange eau/éthanol.

Ces solvants de dispersion ont été sélectionnés pour leur propriété de dispersion des nanoparticules amorphes (concentration, stabilité du colloïde, viscosité, non toxicité), permettant de former un colloïde liquide, homogène et stable avec des nanoparticules amorphes de petites tailles, qui ne précipitent pas naturellement à température ambiante avant au moins 24 heures, et peuvent être déposées par pulvérisation (viscosité, pression de vapeur et température d'évaporation) dans des conditions optimales afin d'obtenir un film continu, homogène et sans impuretés tel que décrit ci-après.

Un alcool présentant un point d'ébullition inférieur à celui de l'eau est avantageux car dans un procédé de fabrication de film obtenu par dépôt, par pulvérisation et recuit de la dispersion colloïdale sur un substrat tel que décrit ci-après, lors du contact de la solution colloïdale sur la plaque chaude du substrat, il y a évaporation des solvants et, il apparait préférable que l'alcool s'évapore avant l'eau pour écarter les risques de contamination résiduel en carbone provenant dudit alcool au sein dudit film.

L'éthanol et le propanol sont préférés du fait de leur miscibilité totale dans l'eau, outre leur température d'ébullition inférieure à celle de l'eau (et pression de vapeur supérieure à celle de l'eau).

On définit la température ambiante utilisée pour la préparation des solutions ainsi que lors du mélange des étapes a) à c) comme étant une température comprise entre 0°C et 50°C, de préférence de 20 à 40°C.

Ce procédé de préparation de dispersion colloïdale selon l'invention est donc particulièrement avantageux en ce que :
- il est réalisé à température réduite notamment à température ambiante et pression atmosphérique,
- il est quasi instantané et fournit un colloïde homogène et stable, et
- il permet la mise en oeuvre de solvant aqueux en l'absence de solvant toxique et/ou de ligand organique à liaison covalente, et
- l'acétonitrile n'est pas un solvant dangereux ou toxique et permet de protéger les atomes des cations métalliques contre l'oxydation ou contre l'hydrolyse des précurseurs et/ou des particules formées, sans être engagé dans une liaison covalente contrairement à un ligand.

La rapidité de la réaction à l'étape c), typiquement réalisée dans un laps de temps inférieur à une minute, même inférieur à 5 secondes, est la conséquence de l'absence de ligand complexant et liant ledit métal et la présence concomitante de précurseur sulfure.

Cette rapidité de réaction des précurseurs à l'étape c), contribue à obtenir des nanoparticules amorphes et de plus petites tailles, les nanoparticules n'ayant pas le temps de grandir les unes au dépend des autres.

D'autre part, les concentrations élevées et petites tailles de nanoparticules confèrent une plus grande stabilité du colloïde de nanoparticules obtenues à l'étape c), celles-ci restant stable au moins deux jours à température ambiante.

La dispersion colloïdale obtenue permet en outre d'obtenir un film de sulfure(s) de Cu, Zn et Sn cristallin(s) à gros grains conformément au but de la présente invention après dépôt et recuit d'une couche de nanoparticules de sulfure(s) de Cu, Zn et Sn amorphes sur un substrat.

Ce procédé de préparation de dispersion colloïdale est particulièrement avantageux en ce que :
- il est réalisé à température ambiante et pression atmosphérique,
- il est quasi instantané et fournit un colloïde stable,
- il permet la mise en oeuvre de solvant aqueux en l'absence de solvant toxique et/ou de ligand organique à liaison covalente et sans ajout d'acide,
- l'acétonitrile n'est pas un solvant dangereux ou toxique et permet de protéger les atomes des cations métalliques contre l'oxydation ou contre l'hydrolyse des précurseurs et/ou des particules formées, sans être engagé dans une liaison covalente contrairement à un ligand, et
- les sous-produits de réaction sont plus facilement dissous et éliminés à l'aide d'un nombre d'étapes de rinçage moindre avec des solvants de rinçage aqueux, alcoolique ou hydro-alcoolique.

La dispersion colloïdale obtenue est stable et permet en outre d'obtenir un film de sulfure(s) métallique(s) cristallin(s) compacte à gros grains conformément au but de la présente invention après dépôt et double recuit d'une couche de nanoparticules de sulfure(s) de Cu, Zn et Sn amorphes sur un substrat.

De préférence encore, dans le procédé de préparation de la dispersion colloïdale:
- à l'étape a), on réalise une dite première solution aqueuse de NaSH, et
- à l'étape b), on réalise une dite deuxième solution contenant CuCl₂, ZnCl₂ et SnCl₄ dans de l'acétonitrile en mélange avec de l'eau, de préférence dans un rapport volumique acétonitrile/eau d'au moins 50/50, ou de préférence encore de l'acétonitrile pur, et
- à l'étape c), on obtient des nanoparticules amorphes de sulfure(s) de Cu, Zn et Sn, de préférence de composé CZTS de taille de 3 à 20 nm.

Plus particulièrement encore, à l'étape 1), on pulvérise une dite dispersion hydro-alcoolique colloïdale avec un gaz porteur constitué d'un gaz sans oxygène de préférence un gaz neutre, de préférence encore de l'azote, à pression atmosphérique et à une température de substrat porté à au moins 100°C, pour former sur un dit substrat, une couche d'épaisseur de 0,5 à 15 µm de préférence d'environ 0,5 à 10 µm avant recuit.

Dans un mode préféré de réalisation du procédé de préparation de couche mince selon l'invention, après l'étape 2) de traitement thermique par double recuit, on réalise une étape de nettoyage chimique de ladite couche à l'aide d'une solution acide, de préférence une solution de HCl, puis ladite couche mince est rincée avec de l'eau et séchée. Ce traitement de nettoyage chimique permet d'améliorer les performances d'un dispositif photovoltaïque contenant une dite couche mince d'absorbeur, comme démontré ci-après.

Avantageusement, ledit substrat est un substrat destiné à être recouvert d'une couche d'absorption de semi-conducteur de type p dans un dispositif photovoltaïque solide.

Plus particulièrement, ledit substrat est constitué d'une couche de verre ou d'acier recouvert d'une couche dite de contact arrière constituée d'une couche de molybdène, utile dans un dispositif photovoltaïque solide de type substrat.

Dans un dispositif photovoltaïque solide dit de type substrat, les couches ci-dessus sont complétées par :
- une grille métallique appliquée contre ladite couche de contact avant, constituant ainsi la face avant (côté soleil) du dispositif, et
- une couche de verre ou acier appliquée contre ladite couche de contact arrière.

La présente invention fournit également une couche mince et compacte de matériau absorbeur composé essentiellement de sulfure(s) de Cu, Zn et Sn avec des pourcentages atomiques des trois métaux Cu, Zn et Sn pouvant varier dans l'intervalle de x=40 à 60% pour le Cu et y= 15 à 35% pour le Zn et z= 15 à 35% Sn, avec x+y+z=100% de composition homogène composé essentiellement de CZTS, à gros grains cristallins de tailles moyennes d'au moins 500 nm accolés en contact direct entre eux, ladite couche mince d'absorbeur d'épaisseur de 0,5 à 5 µm, de préférence de 0,5 à 3 µm, ladite couche mince d'absorbeur étant déposée sur une couche de molybdène d'un substrat, de préférence du verre, recouvert d'une dite couche de molybdène, obtenue par le procédé selon l'invention.

Plus particulièrement encore, ladite couche mince de matériau absorbeur selon l'invention est une couche compacte déposée sur ledit substrat de sorte que le taux de recouvrement de la surface du substrat par ladite couche est de plus de 95%, de préférence plus de 98%, et présente une porosité inférieure à 10%, de préférence une porosité inférieure à 1%. On entend ici par « porosité » le pourcentage de volume vide entre lesdits gros grains accolés au sein de la couche.

Cette propriété de recouvrement de la surface du substrat obtenu par le procédé selon l'invention, avec un taux de recouvrement supérieur à 95%, est originale et avantageuse en ce qu'elle évite le contact direct entre les deux couches adjacentes au film et permet ainsi d'éviter les courts circuits électriques du dispositif photovoltaïque.

On comprend que le taux de recouvrement inférieur à 100% résulte de ce que des espaces vides ouverts peuvent subsister entre les parties des surfaces externes des grains non en contact entre elles du fait que les grains adjacents sont accolés en contact direct sur une partie seulement de leur surface externe.

Ladite couche mince de matériau absorbeur est de composition homogène est constituée essentiellement et exclusivement de gros grains cristallins de CZTS accolés en contact direct entre eux et ne contient pas ou peu de phases secondaires cristallines, en particulier de sulfures de seulement un ou deux métaux choisis parmi Cu, Zn et Sn, notamment pas ou peu de SnS

La présente invention fournit également un dispositif photovoltaïque comprenant une couche d'absorption constituée d'une couche mince de matériau absorbeur déposée sur un substrat selon l'invention.

Plus particulièrement, le film présente une rugosité de surface avec une hauteur moyenne arithmétique des pics Sa, selon la norme ISO 25178, inférieure à la moitié de l'épaisseur e du film, de préférence inférieure à 0,2 x e, de préférence encore inférieure à 0,15 x e pour une surface d'au moins 20x20 µm². La mesure de la rugosité de surface d'un film a été réalisée avec un microscope à force atomique (AFM) et microscope à sonde locale (SPM), de modèle AFM/SPM de Agilent Tech. (U.S.A.), série 5100.

Plus la rugosité est grande, plus la surface réelle de la couche est grande et plus il peut y avoir des recombinaisons de surface lesquelles diminuent le rendement photovoltaïque du dispositif photovoltaïque contenant une dite couche d'absorbeur.

Plus particulièrement, la présente invention fournit un dispositif photovoltaïque selon l'invention comprenant des couches successivement empilées :
- un substrat, de préférence du verre sodo-calcique, recouvert d'un fine couche conductrice de molybdène servant de couche contact électrique arrière,
- une dite couche mince de matériau absorbeur, constituée essentiellement de CZTS,
- une dite couche tampon, de préférence une couche faite à base de sulfure de cadmium CdS,
- une couche transparente conductrice de contact avant, de préférence une couche d'une première couche de ZnO dite intrinsèque (non-dopée), recouverte d'une couche conductrice transparente, de préférence d'oxyde d'indium dopé étain (ITO en anglais) ou oxyde de zinc dopé aluminium (AZO, en anglais), et
- des fins collecteurs métalliques sur ladite couche transparente de contact électrique face avant, à savoir, une grille métallique (d'aluminium, nickel et/ou argent).

D'autres caractéristiques qui avantagent la présente invention apparaitront à la lumière des exemples détaillés de réalisation qui vont suivre en référence aux figures suivantes.

Dans les exemples ci-après, lorsque l'on réalise un double recuit, lors de la première étape l'atmosphère du gaz est constituée exclusivement d'azote ou d'argon, et lors de la deuxième étape l'atmosphère est constituée d'azote ou d'argon contenant 3% de H₂S dénommée dans la présente description « atmosphère d'H₂S ».

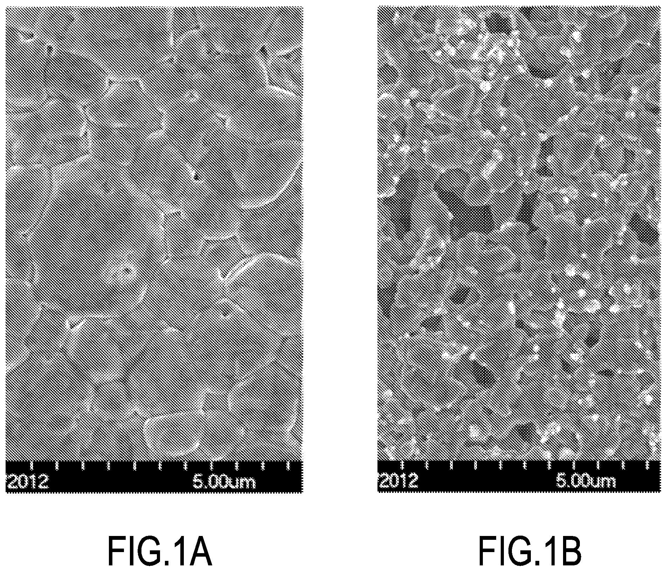

Les figures 1A et 1B montrent deux images MEB des couches CZTS en vue par-dessus : compacte et à gros grains comme celle obtenue dans l'Exemple 1 recuite selon l'invention (figure 1A) et poreuse comme dans l'exemple comparatif 4, recuite avec une seule étape sous atmosphère H₂S (figure 1B).

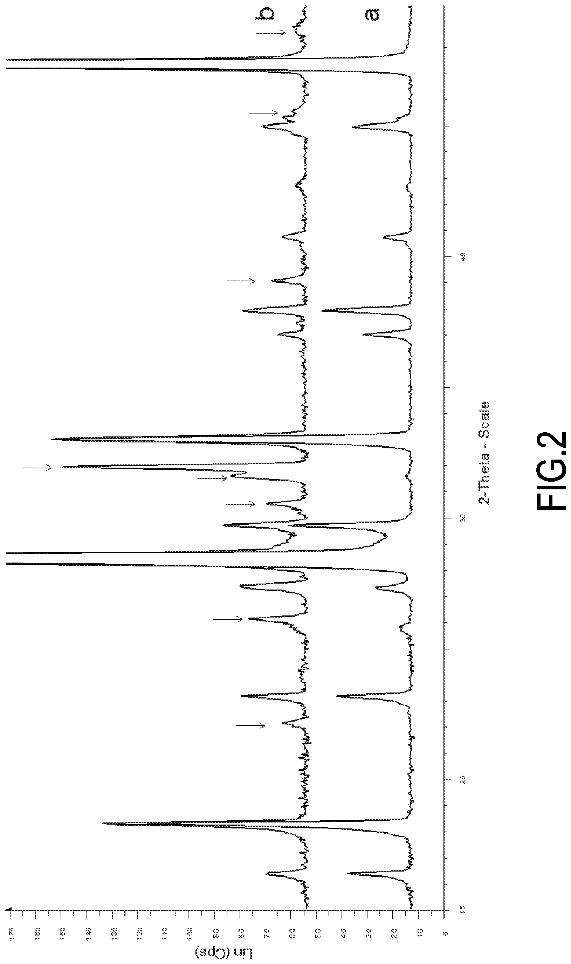

La figure 2 montre deux diffractogrammes de rayons X (DRX) des couches CZTS : la couche obtenue dans l'Exemple 1, recuite selon l'invention (diffractogramme a); et la couche obtenue dans l'exemple comparatif 3, recuite avec une seule étape sous atmosphère N₂ (diffractogramme b). Les diffractogrammes ont été obtenus avec un appareil commercial utilisant la radiation Cu K alpha. Les flèches sur le diffractogramme (b) correspondent à la phase secondaire SnS. Les valeurs Cps («Count per second ») en ordonnées sont en échelle linéaire (« Lin »).

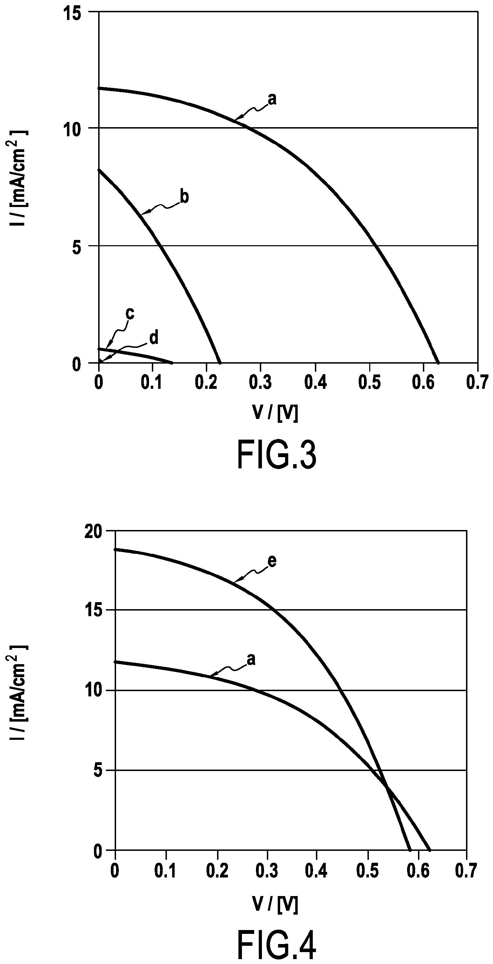

La figure 3 représente des courbes I-V des dispositifs photovoltaïques CZTS : la courbe (a) correspond à une couche CZTS recuite selon le procédé de l'invention, selon l'Exemple 2, la courbe (b) correspond à une couche CZTS recuite à une étape sous atmosphère N₂, selon l'Exemple comparatif 3 ; la courbe (c) correspond à une couche CZTS recuite à une étape sous atmosphère H₂S, selon l'Exemple comparatif 4 ; la courbe (d) correspond à une couche CZTS recuite à deux étapes (première sous N₂, deuxième sous vapeurs de SnS et S), selon l'Exemple comparatif 8.

La figure 4 représente les couches I-V des dispositifs photovoltaïques comprenant une couche CZTS recuite selon le procédé de l'invention : la courbe (a) correspond à une couche de CZTS recuite selon l'exemple 2, la courbe (e) correspond à une couche de CZTS recuite selon l'exemple 3, avec une étape supplémentaire de nettoyage chimique à l'acide chlorhydrique de la couche de CZTS après recuit et avant le dépôt de la couche tampon CdS.

La morphologie des couches CZTS (épaisseur, taux de recouvrement, porosité, taille de grains) peut être vérifiée par Microscopie Électronique à Balayage (MEB), éventuellement aussi par microscopie électronique à transmission (MET), dans différents zones de la couche, en vues par-dessus et en vues en tranche.

Les phases cristallines présentes dans les couches CZTS peuvent être analysées par Diffraction des Rayons X (DRX), typiquement à angle rasant de 1 à 3degrés.

La composition élémentaire moyenne des couches peut être analysée par spectroscopie de rayons X à dispersion d'énergie (en anglais Energy Dispersive X-ray spectroscopy, EDX ou EDS), couplée à un appareil MEB, sur des surfaces de dizaines ou centaines de micromètres de côté. L'homogénéité de la composition élémentaire peut être évaluée en plus par cartographie EDX en vues par-dessus.

La performance photovoltaïque des dispositifs photovoltaïques est mesurée à partir des courbes courant-tension (I-V) sous irradiation d'un simulateur solaire à la puissance standard de 1000 W/m². De ces courbes on calcule le rendement de conversion de la radiation incidente en puissance électrique au point de puissance maximum, et d'autres paramètres de performance tel que le photo-courant à court-circuit et la tension à circuit ouvert.

Dans l'exemple 1 on décrit la fabrication d'une couche mince CZTS en utilisant une dispersion colloïdale des particules CZTS et le procédé de double recuit de la présente invention. Chaque étape de recuit comprend une rampe de montée depuis la température ambiante jusqu'à la température maximum (typiquement dans un temps de 50 minutes), suivie d'un plateau à cette température maximum (typiquement de 15 à 60 minutes), suivi d'un refroidissement jusqu'à température ambiante.

Dans l'exemple 2 on décrit la fabrication d'un dispositif photovoltaïque fait avec la couche mince CZTS de l'Exemple 1. Dans les exemples comparatifs 3 à 6 on décrit des couches et des dispositifs faits avec la même technique mais recuites selon un procédé de recuit à une seule étape (une seule atmosphère).

La couche CZTS de l'exemple comparatif 3, recuite sous atmosphère neutre d'azote, est compacte et à gros grains (de l'ordre d'un micromètre). Elle présente des phases cristallines secondaires, spécialement du SnS, tel que montré par analyse de diffraction de rayons X (DRX) ; la cartographie EDX montre quelques zones beaucoup plus riches en Cu et quelques zones plus riches en Zn par rapport à la composition moyenne de la couche. Des dispositifs photovoltaïques faits avec ce type de couche ont montré un rendement bas, inférieur à 1%.

La couche CZTS de l'exemple comparatif 4, recuite sous atmosphère contentant du gaz H₂S dilué dans l'argon ou dans l'azote, présente très peu ou pas de phases cristallines secondaires telles que le SnS, comme montré par DRX. Les couches ne sont pas assez denses et les grains ne sont pas assez grands. Des dispositifs photovoltaïques faits avec ce type de couche présentaient une performance très basse.

La couche CZTS de l'exemple comparatif 5, recuite sous atmosphère contentant de la vapeur de S élémentaire, présente très peu ou pas de phases secondaires telles que le SnS, comme montré par DRX. Les couches ne sont pas assez denses et les grains ne sont pas assez grands.

La couche CZTS de l'exemple comparatif 6, recuite sous atmosphère contentant de la vapeur de SnS, présente peu de phases secondaires telles que le SnS (estimé à moins de 1%), comme montré par DRX. Les couches ne sont pas assez denses et les grains ne sont pas assez grands.

La couche CZTS de l'exemple 1 a été recuite en deux étapes, une première sous atmosphère neutre de N₂, et une deuxième sous atmosphère de H₂S dilué dans du N₂ ou Ar. Après la deuxième étape de recuit, la couche garde la compacité et la taille de grains obtenus après la première étape. Elle ne présente pas ou peu de phases secondaires telles que le SnS (estimé à moins de 0,5%), comme montré par DRX ; la cartographie EDX montre quelques zones riches en Zn, pas des zones différenciées riches en Cu, le reste étant homogène, avec le même taux que la moyenne de la couche.

Les dispositifs photovoltaïques CZTS de l'exemple 2 faits avec des couches recuites de l'exemple 1 avec ce procédé de recuit à deux étapes ont montré des performances photovoltaïques largement améliorées, notamment, des rendements supérieurs à 3% et des tensions à circuit-ouvert supérieurs à 0,45V, plus particulièrement supérieurs à 0,5V. La performance de ces dispositifs peut être amélioré par un ajustement plus précis de la composition de la couche (tel que connu dans l'état de l'art) et par des ajustements des épaisseurs et compositions de couches annexes (tampon, conductrice avant et arrière).

Dans l'exemple comparatif 10 on montre l'effet du substrat Mo par rapport à un substrat verre lors d'un recuit en atmosphère neutre ; le substrat Mo permet d'obtenir une couche compacte, contrairement au substrat verre.

Dans l'exemple 11 on décrit la fabrication d'un dispositif photovoltaïque fait avec la couche mince CZTS de l'Exemple 1, suivi d'une étape de nettoyage chimique, le dispositif photovoltaïque étant fini comme dans l'exemple 2.

Le Tableau 1 ci-après résume les résultats des analyses des couches CZTS sur substrat Mo après plusieurs types de recuit à une étape.

On a réalisé d'autres recuits à deux étapes, où la première étape était un recuit sous N₂ et la deuxième étape était un recuit dans une atmosphère contenant des vapeurs de S, de SnS + S, ou de SnS₂, tel que décrit dans les exemples comparatifs 7 à 9. La morphologie ou homogénéité des couches et/ou la performance photovoltaïque n'étaient pas satisfaisantes.

Le Tableau 2 ci-après résume les résultats des analyses des couches CZTS sur substrat Mo après plusieurs types de recuit à deux étapes.

Le Tableau 3 ci-après résume les performances des dispositifs faits avec des couches CZTS sur Mo recuites avec différents procédés de recuit.

Le recuit était réalisé avec une rampe de montée en température de 50 minutes depuis la température ambiante jusqu'à la température maximale, suivie d'un plateau à cette température maximale, suivi d'un refroidissement jusqu'à la température ambiante naturellement ou forcé pour aller plus vite.

**TABLEAU 1 : Analyse des couches CZTS sur substrat Mo après plusieurs types de recuit à une étape ; une couche CZTS sur substrat verre (sans Mo) est rajouté à titre comparatif.**

| Descriptif du Recuit | Morphologie(MEB) | | Phases autres que CZTS assignées par DRX | Homogénéité Cartographie Cu-Zn-Sn par EDX |
|---|---|---|---|---|
| | Compacité | Taille de grains | | |
| Pas de recuit | Pas dense | ∼10nm | Amorphe | Homogène Pas des zones différenciées |
| 525°C 15-60 min, sous N₂ | Dense | 1µm | SnS | Zones riches en Cu, ou en Zn, ou légèrement en Sn |
| 525°C 15 min, sous N₂ ; substrat verre sans Mo | Pas dense | <500nm | Pas de SnS | |
| 525°C 15-60 min, sous atmosphère SnS | Pas dense | <500nm | SnS | |
| 550°C 60 min, sous atmosphère SnS | Dense | ∼1µm | SnS | |
| 550°C 60 min, sous atmosphère S | Pas dense | <500nm | SnS | |
| 570°C 60 min, sous atmosphère S | Pas dense | 500nm-1µm | Pas de SnS | |
| 600°C 60 min, sous atmosphère S | Pas dense* | <500nm-1µm | Pas ou peu de SnS | |
| 525°C 60 min, sous atmosphère H2S | Pas dense | <500nm | Pas ou peu de SnS | |
| 600°C 60 min, sous atmosphère H2S | Pas dense* | <500nm | Pas ou peu de SnS | |

| | | | | |
|---|---|---|---|---|
| * le substrat verre est courbé après recuit | | | | |

**TABLEAU 2 : Analyse des couches CZTS sur substrat Mo après plusieurs types de recuit à deux étapes**

| 1ère étape de recuit | 2ème étape de recuit | Morphologie (MEB) | Phases autres que CZTS assignées par DRX | Homogénéité Cartographie Cu-Zn-Sn par EDX |
|---|---|---|---|---|
| 50'rampe, 525°C 15min, sous N2 | 50'rampe, 525°C 60min, sous H2S | Dense Grains ∼1µm | Pas ou peu de SnS | Petites zones légèrement riches en Zn |
| 50'rampe, 525°C 15min, sous N2 | 50'rampe, 525°C 60min, sous S | Dense Grains attaqués | SnS | |
| 50'rampe, 525°C 15min, sous N2 | 50'rampe, 525°C 60min, sous SnS+S | Dense Présence surcouche d'aspect différent | Peu de SnS | |
| 50'rampe, 525°C 15min, sous N2 | 50'rampe, 525°C 60min, sous SnS2 | Dense | Peu de SnS | |

**TABLEAU 3 : Performances des dispositifs faits avec des couches CZTS sur Mo recuits avec différent procédés, et mesurés à une irradiance de 1000W/m² à 25°C selon les exemples 1 à 10.**

| 1ère étape de recuit | 2ème étape de recuit | Rendement [%] | Photo-courant [mA/cm2] | Tension à circuit ouvert [V] |
|---|---|---|---|---|
| 50'rampe, 525°C 15min, sous azote | - | <0,6% | <8 mA/cm2 | <0,25V |
| 50'rampe, 525°C 60min, sous H2S | - | <0,1% | <1 mA/cm2 | <0,1 V |
| 50'rampe, 525°C 15min, sous N2 | 50'rampe, 525°C 60min, sous SnS+S | Faible | Faible | <0,005V |
| 50'rampe, 525°C 15min, sous N2 | 50'rampe, 525°C 60min, sous SnS2 | Faible | Faible | <0,015V |
| 50'rampe, 525°C 15min, sous N2 | 50'rampe, 525°C 60min, sous H2S | >3% | 10-17mA/cm2 | 0,45-0,63V |

Exemple 1. Fabrication d'une couche mince de CZTS en utilisant une dispersion colloïdale de CZTS et recuite avec un procédé de recuit à deux étapes, une première en atmosphère neutre, et une deuxième en atmosphère H₂S.A) Préparation d'un colloïde de CZTS

Un colloïde de nanoparticules de Cu-Zn-Sn-S a été fabriqué en faisant réagir un mélange de sels métalliques de CuCl, ZnCl₂ et SnCl₄.5H₂O dans l'eau/acétonitrile avec une solution aqueuse de NaSH, à température ambiante et sous atmosphère neutre d'azote, selon la réaction globale :

2CuCI + ZnCl₂ + SnCl₄ + 4NaSH ⇔ Cu₂ZnSnS₄ + 4NaCl + 4HCl

Ce système réactif est adapté dans le sens que les sous-produits de réaction, par exemple NaCl ou HCl, sont solubles dans l'eau tandis que les nanoparticules sont solides, et dispersées sous forme de colloïde.

On a préparé une solution aqueuse de 0,12 M de NaSH dans l'eau déionisée. On a préparé une solution des chlorures métalliques de cuivre, zinc et étain mentionnée ci-dessus dans l'acétonitrile en boîte à gants d'azote, à une concentration de ∼0,5M en Cu, ∼0,25M en Zn et ∼0,25M en Sn (typiquement 469 mg de CuCl, 415mg de ZnCl₂ et 893 mg de SnCl₄.5H₂O dans 10ml d'acétonitrile). On a pris 1 volume de la solution de chlorures de métaux, on a rajouté 4 volumes d'acétonitrile et 5 volumes d'eau. A cette solution on a rajouté 10 volumes de la solution de NaHS, donnant rapidement une dispersion colloïdale. Le colloïde ainsi obtenu est lavé dans l'eau et l'éthanol par des étapes successives de centrifugation, retrait de surnageant et ré-dispersion. Le précipité après la dernière centrifugation est ré-dispersé (et concentré par rapport au volume initial) par addition de 5 volumes d'éthanol.

Les particules du colloïde rincé ont été analysées par microscopie électronique à transmission MET, qui a montré des nanoparticules de forme arrondie, agglomérées et de tailles entre 2 et 7 nm typiquement.

Quelques gouttes du colloïde ont été déposées sur un substrat de verre dans une boîte à gants en azote, laissées sécher, puis le dépôt sec du colloïde a été recuit dans l'azote pendant une heure à 525°C. La caractérisation DRX a donné les pics typiques du Cu₂ZnSnS₄ ; l'analyse élémentaire par EDX du dépôt recuit a donné des pourcentages Cu:Zn:Sn moyens (statistique sur plusieurs lots) de 48:29:23.

### B) Préparation d'un film de CZTS cristallisé sur substrat de verre recouvert de molybdène.

Le dépôt du film de CZTS a été fait par pulvérisation (« spray » en anglais) dans une boîte à gants remplie d'azote. On a préparé une dispersion colloïdale en mélangeant 2 volumes de la dispersion colloïdale éthanolique finale obtenue conformément au paragraphe A ci-dessus avec 18 volumes d'eau. Des substrats commerciaux de verre sodo-calcique avec une couche de Mo, de dimensions 2,5x2,5 cm, ont été placés sur une plaque chauffante à une température de 300°C. La buse du spray utilisée a été un flacon pulvérisateur sur éprouvette en verre borosilicate. Pour l'injection de la solution colloïdale dans la buse, l'application d'une pression d'azote a été contrôlée de façon intermittente : ouvert 0,3 seconde puis attente 1,7 seconde, ce cycle de 2 secondes étant maintenu pendant la durée du dépôt, qui a été de 2 minutes et demie. La distance buse-substrat a été d'environ 15 cm avec un flux moyen de gaz porteur azote de 14 L/min à une pression de bouteille azote de 0,2 bar au dessus de la pression atmosphérique. On a obtenu ainsi une couche colorée uniforme à la vue.

On a réalisé une première étape de recuit sous atmosphère N₂ sur une plaque chauffante placée dans une boîte à gants remplie à l'azote sec, avec un plateau à 525°C pendant 15 min (avec une montée en température (ci-après dénommée par « rampe ») pendant 50 minutes suivi d'un refroidissement naturel à température ambiante aux alentours de 25-30°C.

On a réalisé une deuxième étape de recuit sous une atmosphère H₂S, dans un four tubulaire, sous flux de H₂S à 3% dans l'argon, avec un plateau à 525°C pendant 60 minutes avec une montée en température pendant 50 minutes et un refroidissement naturel jusqu'à une température ambiante de 20-40°C.

Après ce double recuit la couche était dense ou compacte et la taille de grains de l'ordre de 1 µm, d'après une analyse MEB en vue dessus. Une vue de section du film obtenu après recuit a montré des épaisseurs du film CZTS aux alentours de 2 à 3 µm. Le film présente une rugosité de surface avec une hauteur moyenne arithmétique des pics, Sa, de 250 nm pour de surfaces d'analyse d'au moins 20x20 µm². D'après l'analyse DRX les pics correspondant à la phase cristalline secondaire SnS (comme montré sur la Figure 2) n'étaient pas présents ou ils étaient très faibles (pour différents échantillons faits dans les mêmes conditions). La cartographie EDX de la composition atomique élémentaire des trois métaux dans la couche a révélé quelques zones micrométriques légèrement plus riches en Zn de plus de 10% par rapport au pourcentage Cu:Zn:Sn moyen de la couche.

Exemple 2. Fabrication d'un dispositif photovoltaïque du type couche mince réalisé avec une couche CZTS fabriquée et recuite comme dans l'Exemple 1.

Sur la couche CZTS de l'Exemple 1 on a déposé une couche tampon de CdS de 50 nm approximativement, par dépôt chimique (Chemical Bath Déposition, CBD, en anglais), suivant la procédure usuel de l'état de l'art. Sur cette couche on a déposé successivement une couche transparente de ZnO de 50 nm approximativement, suivie d'une couche transparente conductrice d'oxyde d'indium dopé Sn (ITO, en anglais) de 250 nm approximativement, par pulvérisation cathodique magnétron en utilisant un appareil commercial. Ensuite, le substrat a été divisé en 16 cellules électriquement isolées, des dimensions 0,5x0,5 cm. Un petit point d'argent a été déposé (par séchage d'une laque chargée en argent) sur la couche transparente de contact avant afin de collecter le courant et placer un des contacts pour mesurer la performance photovoltaïque. Le deuxième contact a été fait directement sur la Mo au bord du substrat.

Le rendement photovoltaïque a été mesuré avec un test standard en réalisant des courbes courant-tension sous simulateur solaire, tel que décrit dans le brevet FR2899385.

Le rendement photovoltaïque (ou efficacité photovoltaïque) a été calculé à partir des caractéristiques électriques courant-tension de la diode photovoltaïque mesurées sous irradiation lumineuse. Le rendement de conversion est le pourcentage de la puissance électrique délivrée par le dispositif au point de puissance maximum, par rapport à la puissance de la radiation incidente : η= (puissance électrique au point de puissance maximum)/(puissance de la radiation incidente). Cette efficacité photovoltaïque a été mesurée avec un banc de test électrique et qui utilise un simulateur solaire délivrant une irradiation de 1000 W/m² correspondant à la norme AM1.5G. Le banc de mesure a été calibré selon la procédure standard sur la base du photo-courant connu de cellules de référence, telles que fournies par différents instituts officiels reconnus.

La meilleure performance a été un rendement supérieur à 3%, avec des courants à court-circuit de 10 à 17 mA/cm² et des tensions à circuit ouvert de 0,45 à 0,63V.

Exemple comparatif 3. Fabrication d'une couche mince de CZTS en utilisant une dispersion colloïdale de CZTS et recuite avec une seule étape de recuit dans une atmosphère neutre de N₂, et d'un dispositif photovoltaïque du type couche mince réalisé avec cette couche.

On a préparé une couche comme dans l'Exemple 1, mais recuite seulement avec la première étape sous atmosphère N₂. Avant recuit la couche était poreuse et formée de petits grains de ∼10nm. Après ce recuit la couche était dense et la taille de grains de l'ordre de 1 µm. D'après l'analyse DRX, outre la phase CZTS, on a détecté des pics correspondant à la phase SnS. La cartographie EDX de la composition atomique élémentaire des trois métaux dans quelques parties de la couche a révélé quelques zones micrométriques très riches en Cu (plus de 25%), ou plus riches en Zn, ou en Sn par rapport au pourcentage Cu:Zn:Sn moyen de la couche.

D'autres conditions de recuit (en diminuant le temps de montée ou en augmentant la température du plateau) ont donnés des résultats similaires.

Avec cette couche on a fabriqué des dispositifs photovoltaïques en suivant la procédure de l'Exemple 2. Le meilleur rendement a été inférieur à 0,6%, les courants à court-circuit ont été inférieures à 8 mA/cm² et les tensions à circuit ouvert inférieurs à 0,25V.

Exemple comparatif 4. Fabrication d'une couche mince de CZTS en utilisant une dispersion colloïdale de CZTS et recuite avec une étape dans une atmosphère de H₂S, et d'un dispositif photovoltaïque du type couche mince réalisé avec cette couche.

On a préparé des couches comme dans l'Exemple 1, mais recuites seulement avec une seule étape, sous atmosphère H₂S (dilué dans l'azote ou dans l'argon), de façon similaire à la deuxième étape de l'Exemple 1, avec une température du plateau entre 525 et 600°C.

La couche après ce recuit n'était pas dense, mais poreuse, et la taille de grains était inférieure à 500nm. D'après l'analyse DRX les pics correspondant à la phase secondaire SnS n'étaient pas présents ou ils étaient très faibles (pour différents échantillons faits dans les mêmes conditions).

Avec des couches recuites à 560°C on a fabriqué des dispositifs photovoltaïques en suivant la procédure de l'Exemple 2. Le meilleur rendement a été <0,1%, les courants à court-circuit inférieures à 1 mA/cm² et les tensions à circuit ouvert inférieurs à 0,1V.

Exemple comparatif 5. Fabrication d'une couche mince de CZTS en utilisant une dispersion colloïdale de CZTS et recuite avec une étape dans une atmosphère contenant de la vapeur de S.

On a préparé des couches comme dans l'Exemple 1, mais recuites seulement avec une seule étape, sous atmosphère contenant de la vapeur de S. Le recuit a été réalisé sur une plaque chauffante placée dans une boîte à gants remplie à l'azote sec : Un creuset contenant de la poudre de S a été place à côté de la couche à recuire, les deux couverts par une cloche en verre, sur une plaque chauffante avec couvercle. Le cycle de chauffe été similaire à celui du recuit sous N₂ de l'Exemple 3, avec un plateau entre 550 et 600°C.

La couche après ce recuit n'était pas dense, mais poreuse. La taille de grains était inférieure à 500nm pour le plateau à 550°C, et ∼500nm-1µm ou inférieur pour les plateaux à 570-600°C. D'après l'analyse DRX les pics correspondant à la phase secondaire SnS n'étaient pas présents ou ils étaient très faibles (pour différents échantillons faits dans les mêmes conditions).

Exemple comparatif 6. Fabrication d'une couche mince de CZTS en utilisant une dispersion colloïdale de CZTS et recuite avec une étape dans une atmosphère contenant de la vapeur de SnS.

On a préparé des couches comme dans l'Exemple 1, mais recuites seulement avec une seule étape, sous atmosphère contenant de la vapeur de SnS. Le recuit a été réalisé sur une plaque chauffante placée dans une boîte à gants remplie à l'azote sec : Un creuset contenant de la poudre de SnS a été place à côté de la couche à recuire, les deux couverts par une cloche en verre, sur une plaque chauffante avec couvercle. Le cycle de chauffe été similaire à celui du recuit sous N₂ de l'Exemple 3, avec un plateau entre 525 et 550°C.

La couche après le recuit avec le plateau à 525°C n'était pas dense, mais poreuse, et la taille de grains était inférieure à 500nm. La couche après le recuit avec le plateau à 550°C était dense et la taille de grains était de l'ordre de 1 µm. D'après l'analyse DRX les pics correspondant à la phase secondaire SnS étaient présents pour la couche après le recuit avec le plateau à 525°C, et ils étaient plus intenses pour la couche après le recuit avec le plateau à 550°C.

Exemple comparatif 7. Fabrication d'une couche mince de CZTS en utilisant une dispersion colloïdale de CZTS et recuite avec un procédé de recuit à deux étapes, une première en atmosphère neutre, et une deuxième en atmosphère contenant de la vapeur de S.

On a préparé une couche comme dans l'Exemple 1, recuite avec deux étapes, une première étape sous atmosphère N₂ (comme dans l'Exemple 1), et une deuxième étape dans une atmosphère contenant de la vapeur de S (et pas du H₂S comme dans l'Exemple 1). La deuxième étape de recuit a été réalisée sur une plaque chauffante placée dans une boîte à gants remplie à l'azote sec : Un creuset contenant de S a été place à côté de la couche à recuire, les deux couverts par une cloche en verre, sur une plaque chauffante avec couvercle. Le cycle de chauffe été similaire à celui du recuit sous N₂ de l'Exemple 3, avec un plateau à 525°C.

La couche après ce recuit était dense, mais les grains présentaient en surface un aspect corrodé différent de celui de l'Exemple 1, comme si elle avait été attaquée. D'après l'analyse DRX les pics correspondant à la phase secondaire SnS étaient présents.

Exemple comparatif 8. Fabrication d'une couche mince de CZTS en utilisant une dispersion colloïdale de CZTS et recuite avec un procédé de recuit à deux étapes, une première étape de recuit en atmosphère neutre, et une deuxième étape dans une atmosphère contenant de la vapeur de SnS et de S, et d'un dispositif photovoltaïque du type couche mince réalisé avec cette couche.

On a préparé une couche comme dans l'Exemple 1, recuite avec deux étapes, une première étape sous atmosphère N₂ (comme dans l'Exemple 1), et une deuxième étape dans une atmosphère contenant de la vapeur de SnS et S (et pas du H₂S comme dans l'Exemple 1). La deuxième étape de recuit a été réalisée sur une plaque chauffante placée dans une boîte à gants remplie à l'azote sec : Un creuset contenant de la poudre de SnS et de S a été place à côté de la couche à recuire, les deux couverts par une cloche en verre, sur une plaque chauffante avec couvercle. Le cycle de chauffe été similaire à celui du recuit sous N₂ de l'Exemple 3, avec un plateau à 525°C.

La couche après ce recuit était dense, avec la présence d'une surcouche d'aspect différent de celui de l'Exemple 1, sans joints de grains bien définis. D'après l'analyse DRX les pics correspondant à la phase secondaire SnS étaient très faibles.

Avec cette couche on a fabriqué des dispositifs photovoltaïques en suivant la procédure de l'Exemple 2. Les performances ont été très faibles, avec de courants à court-circuit et des tensions à circuit ouvert très faibles.

Exemple comparatif 9. Fabrication d'une couche mince de CZTS en utilisant une dispersion colloïdale de CZTS et recuite avec un procédé de recuit à deux étapes, une première en atmosphère neutre, et une deuxième en atmosphère contenant de la vapeur de SnS₂, et d'un dispositif photovoltaïque du type couche mince réalisé avec cette couche.

On a préparé une couche comme dans l'Exemple 1, recuite avec deux étapes, une première étape sous atmosphère N₂ (comme dans l'Exemple 1), et une deuxième étape dans une atmosphère contenant de la vapeur de SnS₂ (et pas du H₂S comme dans l'Exemple 1). La deuxième étape de recuit a été réalisée sur une plaque chauffante placée dans une boîte à gants remplie à l'azote sec : Un creuset contenant de la poudre de SnS₂ a été place à côté de la couche à recuire, les deux couverts par une cloche en verre, sur une plaque chauffante avec couvercle. Le cycle de chauffe été similaire à celui du recuit sous N₂ de l'Exemple 3, avec un plateau à 525°C.

La couche après ce recuit était dense. D'après l'analyse DRX les pics correspondant à la phase secondaire SnS étaient très faibles.

Avec cette couche on a fabriqué des dispositifs photovoltaïques en suivant la procédure de l'Exemple 2. Les performances ont été très faibles, avec des courants à court-circuit et des tensions à circuit ouvert très faibles.

Exemple comparatif 10. Fabrication d'une couche mince de CZTS sur un substrat verre, sans couche de molybdène, en utilisant une dispersion colloïdale de CZTS et recuite avec une seule étape de recuit dans une atmosphère neutre de N₂.

On a préparé une couche comme dans l'Exemple 3, mais sur un substrat verre sodo-calcique sans couche de molybdène, et recuite seulement avec la première étape sous atmosphère N₂. La couche n'était pas dense, mais poreuse, et la taille moyenne de grains était de moins de 500nm.

Exemple 11. Fabrication d'un dispositif photovoltaïque du type couche mince réalisé avec une couche CZTS fabriquée et recuite comme dans l'Exemple 1, et finalisé comme dans l'Exemple 2 mais avec une étape de nettoyage chimique.

La couche CZTS de l'Exemple 1 a été immergée dans une solution d'acide chlorhydrique, HCl, à 8% en poids pendant 1 à 2 minutes. Puis elle a été rincée avec de l'eau déionisée et séchée sous flux d'azote. Immédiatement après on a déposé la couche tampon CdS et le reste de couches pour finir le dispositif photovoltaïque comme dans l'Exemple 2.

La couche présentée dans cet exemple présentait une épaisseur et rugosité identique à celle de l'exemple 2.

Les meilleures performances ont donné des rendements de 5%, avec des courants à court-circuit jusqu'à 19 mA/cm², supérieurs aux dispositifs de l'Exemple 2 où le traitement de nettoyage chimique avec solution acide n'avait pas été effectué, comme montré sur la figure 4.

Il y a lieu de noter que la Voc et le facteur de forme pour le dispositif photovoltaïque obtenu selon cet exemple sont dans la même fourchette de valeurs que pour les dispositifs photovoltaïques de l'exemple 2.

D'autres nettoyages chimiques, tels qu'avec des solutions d'ammoniaque ou de cyanure de potassium, n'ont pas amélioré les performances.

## Revendications

1. Procédé de fabrication d'une couche mince de matériau absorbeur composé essentiellement de sulfure(s) de Cu, Zn et Sn avec des pourcentages atomiques des trois métaux Cu, Zn et Sn pouvant varier dans l'intervalle de x=40 à 60% pour le Cu et y= 15 à 35% pour le Zn et z= 15 à 35% Sn, avec x+y+z=100%, de préférence sous forme de composé quaternaire Cu-Zn-Sn-S ci-après désigné par un composé CZTS, à gros grains cristallins de tailles moyennes au moins de 500nm, ladite couche mince d'absorbeur étant déposée sur un (ou des) matériau(x) en couche(s) formant un substrat, dans lequel on réalise les étapes successives suivantes :
1) on dépose une couche à l'aide d'une dispersion de particules, sous forme de liquide ou de pâte, lesdites particules étant des nanoparticules de sulfure(s) de Cu, Zn et Sn de tailles inférieures à 500 nm, de préférence des particules de CZTS, sur une couche de molybdène (Mo) d'un dit substrat recouvert d'une couche de molybdène (Mo), et
2) on réalise un traitement thermique de recuit de ladite couche déposée sur ledit substrat, à une température maximale d'au moins 300°C, de préférence au moins 450°C, pour obtenir une cristallisation et une croissance des nanoparticules pour obtenir des gros grains cristallins de tailles moyennes d'au moins 500nm, sur une épaisseur de 0,5 à 5 µm, de préférence de 0,5 à 3 µm,
**caractérisé en ce que** ledit traitement thermique comprend deux étapes de recuit dans des atmosphères différentes suivantes successives, à savoir:
- une première étape de recuit dans une atmosphère de gaz neutre tel que l'azote (N₂) ou l'argon (Ar), et
- une deuxième étape de recuit dans une atmosphère de gaz neutre tel que l'azote (N₂) ou l'argon (Ar) contenant du H₂S, de préférence contenant plus de 0,1%, de préférence encore plus de 1% en proportion molaire de H₂S.

2. Procédé de préparation selon la revendication 1, **caractérisé en ce que** la température maximale pour les deux première et deuxième étapes de recuit est de 450 à 600°C, de préférence de 500 à 590°C, et la durée de traitement à ladite température maximale est de 10 à 120 minutes.

3. Procédé selon l'une des revendications 1 ou 2, **caractérisé en ce que** ladite dispersion de particules est une dispersion colloïdale aqueuse, alcoolique ou hydro-alcoolique, de préférence une dispersion colloïdale hydro-alcoolique liquide de nanoparticules amorphes primaires de tailles de 2 à 100 nm, de préférence 3 à 20 nm.

4. Procédé selon la revendication 3, **caractérisé en ce que** ladite dispersion colloïdale est préparée en réalisant les étapes successives suivantes dans lesquelles :
a) on réalise une première solution aqueuse, alcoolique ou hydro-alcoolique de précurseurs de sulfures consistant dans un (ou des) sel(s) métallique(s) de sulfure(s), autres que des sels de cuivre, zinc et étain, ledit sel métallique de sulfure(s) étant de préférence un sel alcalin ou alcalino-terreux, de préférence encore un sel de sodium ou potassium, et
b) on réalise une deuxième solution de précurseurs de cuivre, zinc et étain, autres que des sulfures de cuivre, zinc et étain, en solution dans un solvant comprenant de l'acétonitrile pur ou en mélange avec de l'eau et/ou un alcool, ledit sel de cuivre, zinc et étain étant de préférence un halogénure, de préférence encore un chlorure, et
c) on mélange à pression atmosphérique et température ambiante les 2 dites première et deuxième solutions de précurseurs jusqu'à obtenir une dispersion colloïdale brute, et
d) on sépare la partie solide de ladite dispersion colloïdale de l'étape c), de préférence par centrifugation pour obtenir un précipité du solide après retrait du surnageant liquide, et
e) on rince le précipité solide obtenu à l'étape d) en y versant un solvant aqueux, d'acétonitrile, alcoolique ou hydro-alcoolique pour réformer une dispersion colloïdale, l'alcool de ladite dispersion colloïdale alcoolique ou hydro-alcoolique étant de préférence de l'éthanol, et
f) on sépare à nouveau le précipité solide de ladite dispersion colloïdale de l'étape e), de préférence par centrifugation pour obtenir après retrait du surnageant liquide, un précipité rincé sous forme de pâte humide, et
g) de préférence, on réitère une ou plusieurs fois, les étapes e) et f) de rinçage du colloïde, par centrifugation puis une ré-dispersion dans un solvant aqueux, alcoolique ou hydro-alcoolique.

5. Procédé de préparation selon la revendication 4, **caractérisé en ce que** :
- à l'étape a), on réalise une dite première solution aqueuse de NaSH, et
- à l'étape b), on réalise une dite deuxième solution contenant CuCl₂, ZnCl₂ et SnCl₄ dans de l'acétonitrile en mélange avec de l'eau, de préférence dans un rapport volumique acétonitrile/eau d'au moins 50/50, ou de préférence encore de l'acétonitrile pur, et
- à l'étape c), on obtient des nanoparticules amorphes de sulfure(s) de Cu, Zn et Sn, de préférence de composé CZTS.

6. Procédé selon l'une des revendications 3 à 5, **caractérisé en ce que** à l'étape 1), on pulvérise une dite dispersion aqueuse colloïdale avec un gaz porteur constitué d'un gaz sans oxygène de préférence un gaz neutre, de préférence encore de l'azote, à pression atmosphérique et à une température de substrat porté à au moins 100°C, pour former sur un dit substrat, une couche d'épaisseur de 0,5 à 15 µm de préférence d'environ 0,5 à 10 µm avant recuit.

7. Procédé selon l'une des revendications 1 à 6 **caractérisé en ce qu'**après l'étape 2) de traitement thermique, on réalise une étape de nettoyage chimique de ladite couche mince recuite à l'aide d'une solution acide, de préférence une solution d'acide chlorhydrique, puis ladite couche mince nettoyée est rincée avec de l'eau et séchée.

8. Procédé selon l'une des revendications 1 à 7, **caractérisé en ce que** ledit substrat est un substrat destiné à être recouvert d'une couche d'absorption de semi-conducteur de type p dans un dispositif photovoltaïque solide.

9. Procédé selon la revendication 8, **caractérisé en ce que** ledit substrat est constitué d'une couche de verre ou d'acier recouvert d'une couche dite de contact arrière, constituée d'une couche de molybdène, utile dans un dispositif photovoltaïque solide de type substrat.

10. Couche mince et compacte de matériau absorbeur à base de particules de sulfure(s) de cuivre, zinc et étain, composée essentiellement de sulfure(s) de Cu, Zn et Sn avec des pourcentages atomiques des trois métaux Cu, Zn et Sn pouvant varier dans l'intervalle de x=40 à 60% pour le Cu et y= 15 à 35% pour le Zn et z= 15 à 35% Sn, avec x+y+z=100%, de composition homogène composée essentiellement de CZTS, à gros grains cristallins de tailles moyennes d'au moins 500nm accolés en contact direct entre eux, ladite couche mince d'absorbeur d'épaisseur de 0,5 à 5 µm, de préférence de 0,5 à 3 µm, ladite couche mince compacte de matériau absorbeur étant déposée sur une couche de molybdène d'un substrat, de préférence du verre, recouvert d'une dite couche de molybdène obtenu par le procédé selon l'une des revendications 1 à 9.

11. Couche mince de matériau absorbeur déposée sur un substrat selon la revendication 10, **caractérisée en ce que** ladite couche est une couche compacte déposée sur ledit substrat de sorte que le taux de recouvrement de la surface du substrat par le dépôt de ladite couche est de plus de 95%, de préférence plus de 98%, et dont la couche présente une porosité inférieure à 10%, de préférence pas de porosité apparente.

12. Couche mince selon la revendication 10 ou 11, **caractérisée en ce que** ladite couche mince de matériau absorbeur est de composition homogène ne contenant pas ou peu de phases secondaires cristallines, en particulier de sulfures de seulement un ou deux métaux choisis parmi Cu, Zn et Sn, notamment pas ou peu de SnS.

13. Dispositif photovoltaïque comprenant une couche d'absorption constituée d'une dite couche mince de matériau absorbeur déposée sur un substrat selon l'une des revendications 11 ou 12.

14. Dispositif photovoltaïque selon la revendication 13 de matériau absorbeur déposé sur un substrat comprenant :
- un substrat, de préférence du verre sodo-calcique, recouvert d'un fine couche conductrice de molybdène servant de couche contacte arrière,
- une dite couche mince de matériau absorbeur, de préférence constituée essentiellement de CZTS,
- une couche tampon, de préférence une couche faite à base de sulfure de cadmium CdS,
- une couche transparente de contact avant, de préférence une couche d'une première couche de ZnO dite intrinsèque (non-dopée), recouverte d'une couche conductrice transparente, de préférence d'oxyde d'indium dopé étain (ITO en anglais) ou oxyde de zinc dopé aluminium (AZO, en anglais), et
- des fins collecteurs métalliques sur ladite couche transparente de contact avant.

## Patentansprüche

1. Verfahren zur Herstellung einer dünnen Schicht aus Absorbermaterial, das im Wesentlichen aus Sulfid(en) von Cu, Zn und Sn besteht, mit Atomprozentsätzen der drei Metalle Cu, Zn und Sn, die im Bereich von x = 40 bis 60 % für Cu und von y = 15 bis 35 % für Zn und von z = 15 bis 35 % Sn variieren können, wobei x + y + z = 100 %, vorzugsweise in Form einer quaternären Cu-Zn-Sn-S-Verbindung, nachfolgend mit einer CZTS-Verbindung bezeichnet, mit großen Kristallkörnern mit mittleren Größen von wenigstens 500 nm, wobei die dünne Absorbermaterialschicht auf einem Schichtmaterial (oder -materialien), das (die) ein Substrat bildet (bilden), abgeschieden ist, wobei die folgenden aufeinanderfolgenden Schritte durchgeführt werden:
1) Abscheiden - mit Hilfe einer Partikeldispersion in Form einer Flüssigkeit oder einer Paste, wobei die Partikel Nanopartikel aus Sulfid(en) von Cu, Zn und Sn, mit Größen von weniger als 500 nm, vorzugsweise CZTS-Partikel sind - einer Schicht auf einer Molybdän (Mo)-Schicht eines mit einer Molybdän (Mo)-Schicht überzogenen Substrats, und
2) Durchführen einer Wärmebehandlung zum Glühen der auf dem Substrat abgeschiedenen Schicht bei einer maximalen Temperatur von wenigstens 300 °C, vorzugsweise wenigstens 450 °C, um eine Kristallisation und ein Wachstum der Nanopartikel für den Erhalt von großen Kristallkörnern mit mittleren Größen von wenigstens 500 nm über eine Dicke von 0,5 bis 5 µm, vorzugsweise von 0,5 bis 3 µm zu erreichen,
**dadurch gekennzeichnet, dass** die Wärmebehandlung zwei Glühschritte in folgenden unterschiedlichen aufeinanderfolgenden Atmosphären umfasst, und zwar:
- einen ersten Glühschritt in einer Neutralgasatmosphäre wie Stickstoff (N₂) oder Argon (Ar), und
- einen zweiten Glühschritt in einer Neutralgasatmosphäre wie Stickstoff (N₂) oder Argon (Ar), enthaltend H₂S, vorzugsweise mehr als 0,1 %, weiterhin bevorzugt mehr als 1 % Molanteil H₂S.

2. Herstellungsverfahren nach Anspruch 1, **dadurch gekennzeichnet, dass** die maximale Temperatur für die beiden Glühschritte, den ersten und den zweiten, 450 bis 600 °C, vorzugsweise 500 bis 590 °C beträgt und die Behandlungsdauer bei der maximalen Temperatur 10 bis 120 Minuten beträgt.

3. Verfahren nach einem der Ansprüche 1 oder 2, **dadurch gekennzeichnet, dass** die Partikeldispersion eine wässrige, alkoholische oder hydroalkoholische kolloide Dispersion, vorzugsweise eine flüssige, hydroalkoholische kolloide Dispersion von amorphen Primärnanopartikeln mit Größen von 2 bis 100 nm, vorzugsweise 3 bis 20 nm ist.

4. Verfahren nach Anspruch 3, **dadurch gekennzeichnet, dass** die kolloide Dispersion durch Durchführen der folgenden aufeinanderfolgenden Schritte hergestellt wird, bei denen:
a) eine erste wässrige, alkoholische oder hydroalkoholische Lösung von Sulfidvorläufern, bestehend aus einem (oder mehreren) Metallsalz(en) von Sulfid(en), anderen als Kupfer-, Zink- und Zinnsalzen, hergestellt wird, wobei das Metallsalz von Sulfid(en) vorzugsweise ein Alkali- oder Erdalkalisalz, weiterhin bevorzugt ein Natrium- oder Kaliumsalz ist, und
b) eine zweite Lösung aus Kupfer-, Zink- und Zinn-Vorläufern, anderen als Kupfer-, Zink- und Zinnsulfiden, in Lösung in einem Lösungsmittel, das reines Acetonitril oder in Mischung mit Wasser und/oder einem Alkohol enthält, hergestellt wird, wobei das Kupfer-, Zink- und Zinnsalz vorzugsweise ein Halogenid, weiterhin bevorzugt ein Chlorid ist, und
c) die beiden Vorläufer-Lösungen, die erste und die zweite, bei atmosphärischem Druck und Umgebungstemperatur bis zum Erhalt einer kolloiden Rohdispersion gemischt werden, und
d) der feste Teil von der kolloiden Dispersion des Schrittes c) abgetrennt wird, vorzugsweise durch Zentrifugieren, um einen Niederschlag des Feststoffs nach Entfernen des flüssigen Überstands zu erhalten, und
e) der bei Schritt d) erhaltene feste Niederschlag durch Hineingießen eines wässrigen Lösungsmittels aus Acetonitril, alkoholisch oder hydroalkoholisch, gespült wird, um eine kolloide Dispersion zu reformieren, wobei der Alkohol der alkoholischen oder hydroalkoholischen kolloiden Dispersion vorzugsweise Ethanol ist, und
f) der feste Niederschlag erneut von der kolloiden Dispersion des Schrittes e) abgetrennt wird, vorzugsweise durch Zentrifugieren, um nach Entfernen des flüssigen Überstands einen gespülten Niederschlag in Form einer feuchten Paste zu erhalten, und
g) vorzugsweise die Schritte e) und f) des Spülens des Kolloids, durch Zentrifugieren, dann ein erneutes Dispergieren in einem wässrigen, alkoholischen oder hydroalkoholischen Lösungsmittel einmal oder mehrere Male wiederholt werden.

5. Herstellungsverfahren nach Anspruch 4, **dadurch gekennzeichnet, dass**:
- bei Schritt a) eine erste wässrige NaSH-Lösung hergestellt wird, und
- bei Schritt b) eine zweite Lösung hergestellt wird, die CuCl₂, ZnCl₂ und SnCl₄ in Acetonitril gemischt mit Wasser, vorzugsweise in einem Volumenverhältnis Acetonitril/Wasser von wenigstens 50/50, oder weiterhin bevorzugt reinem Acetonitril, enthält, und
- bei Schritt c) amorphe Nanopartikel aus Cu-, Zn- und Sn-Sulfiden, vorzugsweise aus CZTS-Verbindung erhalten werden.

6. Verfahren nach einem der Ansprüche 3 bis 5, **dadurch gekennzeichnet, dass** bei Schritt 1) eine kolloide wässrige Dispersion mit einem Trägergas, bestehend aus einem sauerstofffreien Gas, vorzugsweise einem Neutralgas, weiterhin bevorzugt Stickstoff, bei atmosphärischem Druck und bei einer Temperatur eines auf wenigstens 100 °C erhitzten Substrats besprüht wird, um auf einem Substrat eine Schicht mit einer Dicke von 0,5 bis 15 µm, vorzugsweise von ca. 0,5 bis 10 µm vor dem Glühen zu bilden.

7. Verfahren nach einem der Ansprüche 1 bis 6, **dadurch gekennzeichnet, dass** nach Schritt 2) der Wärmebehandlung ein Schritt zum chemischen Reinigen der geglühten dünnen Schicht mit Hilfe einer sauren Lösung, vorzugsweise einer Salzsäure-Lösung durchgeführt wird, anschließend wird die gereinigte dünne Schicht mit Wasser gespült und getrocknet.

8. Verfahren nach einem der Ansprüche 1 bis 7, **dadurch gekennzeichnet, dass** das Substrat ein Substrat, welches dazu bestimmt ist, mit einer p-Typ-Halbleiter-Absorptionsschicht beschichtet zu werden, in einer festen Photovoltaikvorrichtung ist.

9. Verfahren nach Anspruch 8, **dadurch gekennzeichnet, dass** das Substrat aus einer Schicht aus Glas oder Stahl besteht, überzogen mit einer von einer Molybdän-Schicht gebildeten, sogenannten Rückkontaktschicht, die in einer festen Photovoltaikvorrichtung von Typ Substrat nützlich ist.

10. Dünne und kompakte Schicht aus Absorbermaterial auf der Basis von Partikeln aus Sulfid(en) von Kuper, Zink und Zinn, im Wesentlichen bestehend aus Sulfid(en) von Cu, Zn und Sn, mit Atomprozentsätzen der drei Metalle Cu, Zn und Sn, die im Bereich von x = 40 bis 60 % für Cu und von y = 15 bis 35 % für Zn und von z = 15 bis 35 % Sn variieren können, wobei x + y + z = 100 %, mit homogener Zusammensetzung, im Wesentlichen bestehend aus CZTS, mit großen Kristallkörnern mit mittleren Größen von wenigstens 500 nm, die in direktem Kontakt untereinander verbunden sind, wobei die dünne Absorbermaterialschicht eine Dicke von 0,5 bis 5 µm, vorzugsweise von 0,5 bis 3 µm aufweist, wobei die dünne, kompakte Absorbermaterialschicht auf einer Molybdän-Schicht eines Substrats, vorzugsweise Glas, das mit einer Molybdän-Schicht überzogen ist, erhalten durch das Verfahren nach einem der Ansprüche 1 bis 9, abgeschieden ist.

11. Dünne Schicht aus Absorbermaterial, abgeschieden auf einem Substrat nach Anspruch 10, **dadurch gekennzeichnet, dass** die Schicht eine auf dem Substrat abgeschiedene kompakte Schicht ist, so dass der Grad der Bedeckung der Oberfläche des Substrats durch die Abscheidung der Schicht mehr als 95 %, vorzugsweise mehr als 98 % beträgt, und dessen Schicht eine Porosität von weniger als 10 %, vorzugsweise keine sichtbare Porosität aufweist.

12. Dünne Schicht nach Anspruch 10 oder 11, **dadurch gekennzeichnet, dass** die dünne Schicht aus Absorbermaterial eine homogene Zusammensetzung aufweist, die keine oder wenige kristalline sekundäre Phasen enthält, insbesondere aus Sulfiden von nur einem oder zwei Metall(en), ausgewählt aus Cu, Zn und Sn, insbesondere kein oder wenig SnS.

13. Photovoltaikvorrichtung mit einer Absorptionsschicht, die aus einer dünnen Schicht aus Absorbermaterial besteht, welche auf einem Substrat nach einem der Ansprüche 11 oder 12 abgeschieden ist.

14. Photovoltaikvorrichtung nach Anspruch 13 aus Absorbermaterial, das auf einem Substrat abgeschieden ist, umfassend:
- ein Substrat, vorzugsweise Kalk-Natron-Glas, überzogen mit einer dünnen leitenden Schicht aus Molybdän, die als Rückkontaktschicht dient,
- eine dünne Schicht aus Absorbermaterial, die vorzugsweise im Wesentlichen aus CZTS besteht,
- eine Pufferschicht, vorzugsweise eine Schicht, die auf Basis von Cadmiumsulfid CdS hergestellt ist,
- eine transparente Frontkontaktschicht, vorzugsweise eine Schicht aus einer sogenannten intrinsischen ersten ZnO-Schicht (undotiert), die mit einer transparenten leitenden Schicht, vorzugsweise aus mit Zinn dotiertem Indiumoxid (ITO im Englischen) oder mit Aluminium dotiertem Zinkoxid (AZO im Englischen) überzogen ist, und
- feine Metallkollektoren auf der transparenten Frontkontaktschicht.

## Claims

1. A method for manufacturing a thin absorber material layer essentially consisting of Cu, Zn and Sn sulphide(s) with atomic percentages of the three metals Cu, Zn and Sn which may vary in the interval from x=40 to 60% for Cu and from y= 15 to 35% for Zn and from z= 15 to 35% for Sn, with x+y+z=100%, preferably as a quaternary compound Cu-Zn-Sn-S designated hereafter as a CZTS compound with large crystal grains of average sizes of less than 500nm, said thin absorber layer being deposited on layered material(s) forming a substrate, wherein the following successive steps are carried out:
1) a layer is deposited by means of a dispersion of particles, as a liquid or a slurry, said particles being nanoparticles of Cu, Zn and Sn sulphide(s) with sizes of less than 500 nm, preferably CZTS particles, on a molybdenum (Mo) layer of a so-called substrate covered with a molybdenum (Mo) layer, and
2) an annealing heat treatment of said layer deposited on said substrate is carried out, at a maximum temperature of at least 300°C, preferably at least 450°C, in order to obtain crystallization and growth of the nanoparticles in order to obtain large crystal grains of average sizes of at least 500 nm, over a thickness from 0.5 to 5 µm, preferably from 0.5 to 3 µm,
**characterized in that** said heat treatment comprises two successive annealing steps in the following different atmospheres, namely:
- a first annealing step in a neutral gas atmosphere such as nitrogen (N₂) or argon (Ar), and
- a second annealing step in a neutral gas atmosphere such as nitrogen (N₂) or argon (Ar) containing H₂S, preferably containing more than 0.1%, still preferably more than 1% in molar proportion of H₂S.

2. The preparation method according to claim 1, **characterized in that** the maximum temperature for both first and second annealing steps is from 450 to 600°C, preferably from 500 to 590°C, and the treatment duration at said maximum temperature is from 10 to 120 minutes.

3. The method according to one of claims 1 or 2, **characterized in that** said dispersion of particles is an aqueous, alcoholic, hydro-alcoholic colloidal dispersion, preferably a liquid hydro-alcoholic colloidal dispersion of primary amorphous nanoparticles with sizes from 2 to 100 nm, preferably 3 to 20 nm.

4. The method according to claim 3, **characterized in that** said colloidal dispersion is prepared by carrying out the following successive steps wherein:
a) a first aqueous, alcoholic, hydro-alcoholic solution of precursors of sulphides consisting in metal sulphide salt(s), other than copper, zinc and tin salts, said metal sulphide(s) salt preferably being an alkaline or earth alkaline salt, still preferably a sodium or potassium salt, and
b) a second solution of copper, zinc and tin precursors, other than copper, zinc and tin sulphides, in solution in a solvent comprising pure acetonitrile or mixed with water and/or an alcohol, said copper, zinc and tin salt preferably being a halide, still preferably a chloride, and
c) both of said first and second solutions of precursors are mixed at atmospheric pressure and at room temperature until a crude colloidal dispersion is obtained, and
d) the solid portion is separated from said colloidal dispersion of step c), preferably by centrifugation in order to obtain a precipitate of the solid after removing the liquid supernatant, and
e) the solid precipitate obtained in step d) is rinsed by pouring thereon an aqueous, acetonitrile, alcoholic or hydro-alcoholic solvent in order to re-form a colloidal dispersion, the alcohol of said alcoholic or hydro-alcoholic colloidal dispersion preferably being ethanol, and
f) the solid precipitate is again separated from said colloidal dispersion of step e), preferably by centrifugation in order to obtain after removing the liquid supernatant, a rinsed precipitate as a humid slurry, and
g) preferably, steps e) and f) for rinsing the colloid, are repeated once or several times by centrifugation and then re-dispersion in an aqueous, alcoholic or hydro-alcoholic solvent.

5. The preparation method according to step 4, **characterized in that**:
- in step a), a so-called first aqueous solution of NaSH is made, and
- in step b), a so-called second solution containing CuCl₂, ZnCl₂ et SnCl₄ in acetonitrile mixed with water, is made preferably in an acetonitrile/water volume ratio of at least 50/50, or still preferably in pure acetonitrile, and
- in step c), amorphous nanoparticles of Cu, Zn and Sn sulphides, preferably of CZTS compound are obtained.

6. The method according to one of claims 3 to 5, **characterized in that** in step 1), a so-called colloidal aqueous dispersion is sprayed with a carrier gas consisting of an oxygen-free gas, preferably a neutral gas, still preferably nitrogen, at atmospheric pressure and a substrate temperature brought to at least 100°C, in order to form on a so-called substrate, a layer with a thickness from 0.5 to 15 µm preferably from about 0.5 to 10 µm before annealing.

7. The method according to one of claims 1 to 6, **characterized in that** after the heat treatment step 2), a step for chemically cleaning said annealed thin layer is carried out by means of an acid solution, preferably a hydrochloric acid solution, and said cleaned thin layer is then rinsed with water and dried.

8. The method according to one of claims 1 to 7, **characterized in that** said substrate is a substrate intended to be covered with an absorption layer of a semiconductor of type p in a solid photovoltaic device.

9. The method according to claim 8, characterizing that said substrate consists of a glass or steel layer covered with a so-called rear contact layer, consisting of a molybdenum layer, useful in a solid photovoltaic device of the substrate type.

10. A thin and compact absorber material layer based on particles of copper, zinc and tin sulphide(s): essentially consisting of Cu, Zn and Sn sulphide(s) with atomic percentages of the three metals Cu, Zn and Sn which may vary in the interval from x=40 to 60% for Cu and y= 15 to 35% for Zn and z= 15 to 35% for Sn, with x+y+z=100%, of a homogeneous composition essentially consisting of CZTS, with large crystal grains of average sizes of at least 500nm placed side by side in direct contact with each other, said thin absorber layer with a thickness from 0.5 to 5 µm, preferably from 0.5 to 3 µm, said compact thin absorber material layer being deposited on a molybdenum layer of a substrate, preferably glass, covered with a so-called molybdenum layer by the method according to one of claims 1 to 9.

11. A thin absorber material layer deposited on a substrate according to claim 10, **characterized in that** said layer is a compact layer deposited on said substrate so that the covering level of the surface of the substrate by the deposit of said layer is more than 95%, preferably more than 98%, and the layer of which has a porosity of less than 10%, preferably no apparent porosity.

12. The thin layer according to claim 10 or 11, characterizing that said thin absorber material layer is of a homogeneous composition containing no or very few secondary crystalline phases, in particular of sulphides of only one or two metals selected from Cu, Zn and Sn, notably no or very little SnS.

13. A photovoltaic device comprising an absorption layer consisting of a so-called thin absorber material layer deposited on a substrate according to one of claims 11 or 12.

14. The photovoltaic device according to claim 13 with absorber material deposited on a substrate comprising:
- a substrate, preferably sodium-lime glass, covered with a thin conductive layer of molybdenum used as a rear contact layer,
- a so-called thin absorber material layer, preferably essentially consisting of CZTS,
- a buffer layer, preferably a layer made on the basis of cadmium sulphide CdS,
- a transparent front contact layer, preferably a layer of a first so-called intrinsic (not doped) ZnO layer, covered with a transparent conductive layer, preferably tin-doped indium oxide (ITO) or aluminium-doped zinc oxide (AZO), and
- thin metal collectors on said transparent front contact layer.
